# EUROPEAN PATENT APPLICATION

(11) **EP 4 661 054 A1**
(43) Date of publication of application: **10.12.2025**
(21) Application number: 24780189.7
(22) Date of filing: 25.03.2024
(51) Int. Cl.: H01L 21/301, B23K 26/364

(54) **WORKPIECE MACHINING APPARATUS**

(30) Priority: 31.03.2023 JP 2023058062
(71) Applicant: Tokyo Seimitsu Co., Ltd., Hachioji-shi, Tokyo 192-8515 (JP)
(72) Inventor: HAYASHI Hirokazu, Hachioji-shi, Tokyo 192-8515 (JP)
(74) Representative: Gill Jennings & Every LLP
(86) International application number: PCT/JP2024/011716
(87) International publication number: WO 2024/204071

(57) **Abstract**

A workpiece machining apparatus includes a table configured to hold a workpiece, a machining unit having a first machining unit and a second machining unit arrayed in an X direction and configured to machine two grooves along a planned machining line by radiating a pair of first laser beams from the first machining unit with respect to the table relatively fed in the X direction along the planned machining line set in a workpiece and machine an area between the two grooves by radiating a second laser beam from the second machining unit between the two grooves machined by the first machining unit, a feed drive unit configured to apply a feed operation in the X direction and a Y direction orthogonal to the X direction by relatively moving the table and the machining unit in the X direction and the Y direction, a correction unit configured to correct a tilt of an array of the first machining unit and the second machining unit for the planned machining line, and a control unit configured to control a tilt correction process of the correction unit.

## Description

### TECHNICAL FIELD

The present invention relates to a workpiece machining apparatus, and more particularly to a workpiece machining apparatus for machining two grooves in a workpiece and machining an area between the two grooves. Priority is claimed on Japanese Patent Application No. 2023-058062, filed March 31, 2023, the content of which is incorporated herein by reference.

### BACKGROUND ART

When chips are created from semiconductor wafers with a low-k (low dielectric constant) film as an interlayer insulating film using a normal blade dicer, there is a problem because delamination occurs.

Patent Document 1 proposes a method of suppressing delamination by machining two grooves along streets with laser beams and cutting an area between the two grooves with a blade as a method of machining a wafer having a low-k film. Moreover, Patent Document 2 proposes a method of cutting an area between two grooves with a laser beam instead of a blade.

On the other hand, Patent Document 3 proposes a method of machining two grooves along a street with laser beams, further hollowing out an area between the two grooves with a laser beam, and removing a laminate containing a low-k film from the street.

### Citation List

### Patent Document

Patent Document 1: Japanese Unexamined Patent Application, First Publication No. 2005-142398
Patent Document 2: Japanese Unexamined Patent Application, First Publication No. 2009-182019
Patent Document 3: Japanese Unexamined Patent Application, First Publication No. 2021-192922

### SUMMARY OF INVENTION

### Technical Problem

In a device for machining two grooves with laser beams and further machining an area between the two grooves with a laser beam, two machining units, i.e., a machining unit for machining the two grooves and a machining unit for machining the area between the two grooves, are arranged in a row along a street. Thereby, two machining processes can be executed simultaneously in a single machining feed operation.

However, in the device configured as described above, if the two machining units are not accurately arrayed along the street, there is a problem because a machining position deviates and the area between the two grooves cannot be accurately machined or accurate machining along the street cannot be performed.

The present invention has been made in consideration of these circumstances and an objective of the present invention is to provide a workpiece machining apparatus capable of machining a workpiece with high precision.

### Solution to Problem

According to a first aspect for solving the above-described problems, there is provided a workpiece machining apparatus including: a table configured to hold a workpiece; a machining unit having a first machining unit and a second machining unit arrayed in an X direction and configured to machine two grooves along a planned machining line by radiating a pair of first laser beams from the first machining unit with respect to the table relatively fed in the X direction along the planned machining line set in a workpiece and machine an area between the two grooves by radiating a second laser beam from the second machining unit between the two grooves machined by the first machining unit; a feed drive unit configured to apply a feed operation in the X direction and a Y direction orthogonal to the X direction by relatively moving the table and the machining unit in the X direction and the Y direction; a correction unit configured to correct a tilt of an array of the first machining unit and the second machining unit for the planned machining line; and a control unit configured to control a tilt correction process of the correction unit.

According to a second aspect, in the workpiece machining apparatus according to the first aspect, the correction unit corrects the tilt occurring in the feed operation of the feed drive unit in the Y direction, and the control unit controls the tilt correction process of the correction unit on the basis of a relative position in the Y direction between the table and the machining unit.

According to a third aspect, the workpiece machining apparatus according to the second aspect further includes a storage unit storing tilt correction information according to the relative position, in which the control unit controls the tilt correction process of the correction unit with reference to the correction information.

According to a fourth aspect, in the workpiece machining apparatus according to the third aspect, the machining unit has a plurality of second machining units, and the second machining units are arranged in front of and behind the first machining unit in the X direction in a state in which the first machining unit is sandwiched therebetween.

According to a fifth aspect, in the workpiece machining apparatus according to any one of the first to fourth aspects, the feed drive unit includes a Y-axis stage moving in the Y direction and an X-axis stage moving in the X direction on the Y-axis stage, the table is mounted on the X-axis stage, and the correction unit corrects the tilt by relatively moving the first machining unit and the second machining unit in the Y direction.

According to a sixth aspect, in the workpiece machining apparatus according to any one of the first to fourth aspects, the feed drive unit includes a Y-axis stage moving in the Y direction and an X-axis stage moving in the X direction on the Y-axis stage, the table is mounted on the X-axis stage, and the correction unit corrects the tilt by integrally rotating the first machining unit and the second machining unit around an axis orthogonal to an XY plane.

According to a seventh aspect, in the workpiece machining apparatus according to any one of the first to fourth aspects, the feed drive unit includes an X-axis stage moving in the X direction and a Y-axis stage moving in the Y direction on the X-axis stage, the table is mounted on the Y-axis stage, and the correction unit corrects the tilt by rotating the table around an axis.

According to an eighth aspect, in the workpiece machining apparatus according to any one of the first to fourth aspects, the feed drive unit includes an X-axis stage independently moving in the X direction and a Y-axis stage independently moving in the Y direction, the table is mounted on the X-axis stage, the machining unit is mounted on the Y-axis stage, and the correction unit corrects the tilt by relatively moving the first machining unit and the second machining unit in the Y direction.

According to a ninth aspect, in the workpiece machining apparatus according to any one of the first to fourth aspects, the feed drive unit includes an X-axis stage independently moving in the X direction and a Y-axis stage independently moving in the Y direction, the table is mounted on the X-axis stage, the machining unit is mounted on the Y-axis stage, and the correction unit corrects the tilt by integrally rotating the first machining unit and the second machining unit around an axis orthogonal to an XY plane. Advantageous Effects of Invention

According to the present invention, it is possible to machine a workpiece with high precision.

### BRIEF DESCRIPTION OF DRAWINGS

[FIG. 1] A plan view showing an example of a semiconductor wafer that is a machining target.
[FIG. 2] A diagram showing an overview of machining.
[FIG. 3] A diagram showing a schematic configuration of a workpiece machining apparatus.
[FIG. 4] A plan view showing a schematic configuration of a table feed drive unit.
[FIG. 5] A diagram showing a schematic configuration of a laser machining head.
[FIG. 6] A diagram showing an example of a configuration of an edge cutting laser beam generation unit.
[FIG. 7] A diagram showing an example of configurations of a hollowing laser beam generation unit and a hollowing optical path switching unit.
[FIG. 8] A conceptual diagram of laser beam irradiation.
[FIG. 9] A conceptual diagram of position adjustment.
[FIG. 10] A block diagram showing an example of an electrical configuration of the workpiece machining apparatus.
[FIG. 11] A flowchart showing a flow of a machining process.
[FIG. 12] A conceptual diagram of the occurrence of a tilt in a machining feed direction of a table due to yawing of a Y-axis stage.
[FIG. 13] A conceptual diagram of a misalignment in a machining position.
[FIG. 14] A conceptual diagram of correction.
[FIG. 15] A diagram showing an example of a machining state after the correction.
[FIG. 16] A block diagram of a function implemented by a control device in relation to correction of a tilt of a condenser lens array.
[FIG. 17] A flowchart showing the flow of the correction process for the tilt of the condenser lens array.
[FIG. 18] A conceptual diagram showing another example of a configuration for correcting a tilt of an array direction of three condenser lenses.
[FIG. 19] A diagram showing a schematic configuration of a workpiece machining apparatus.
[FIG. 20] A diagram showing an example of machining when a tilt occurs in a street.
[FIG. 21] A conceptual diagram of correction.
[FIG. 22] A block diagram of functions implemented by a control device in relation to correction of the tilt of the condenser lens array.
[FIG. 23] A flowchart showing the flow of the correction process for the tilt of the condenser lens array.
[FIG. 24] A diagram showing a schematic configuration of the workpiece machining apparatus.
[FIG. 25] A diagram showing an example of machining when a tilt occurs in the array direction of the condenser lenses.
[FIG. 26] A conceptual diagram of correction.

### DESCRIPTION OF EMBODIMENTS

Hereinafter, preferred embodiments of the present invention will be described with reference to the accompanying drawings.

### [First embodiment]

Here, an example in which the present invention is applied to a device for removing a wiring layer (a laminate) including a low-k film from streets before dicing a semiconductor wafer that uses a low-k film as an interlayer insulating film will be described.

The low-k film serving as the interlayer insulating film is made of a low-k material (a low dielectric constant material). Examples of the low-k material include inorganic materials such as SiO₂, SiOC, and SiLK, polymers such as polyimide, parylene, and polytetrafluoroethylene, and the like. As the examples, these are organic materials, porous silica materials such as methyl-containing polysiloxanes, and the like.

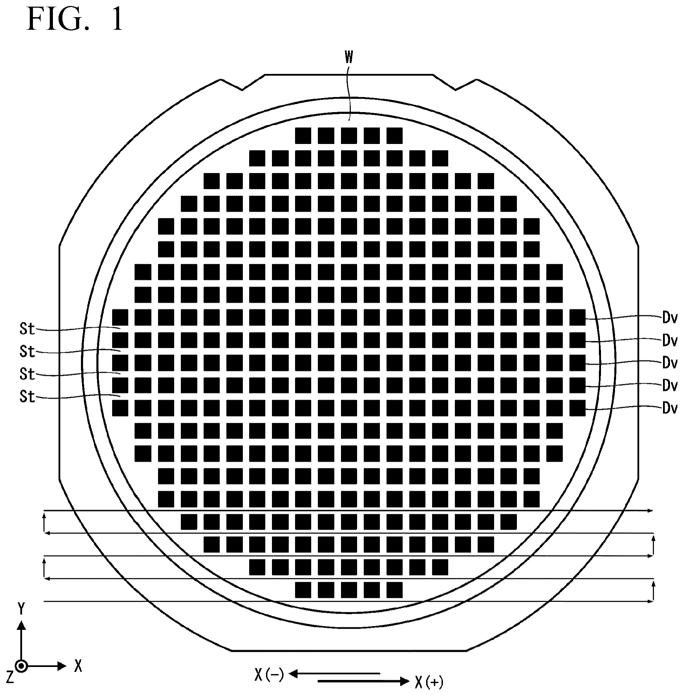

FIG. 1 is a plan view showing an example of a semiconductor wafer that is a machining target.

As shown in FIG. 1, a semiconductor wafer W has devices Dv formed in lattice-like regions partitioned by a plurality of streets St.

In a wafer W using a low-k film as an interlayer insulating film, the low-k film is positioned across the streets St between adjacent devices Dv. Therefore, if the wafer is directly cut with a blade, there is a risk of delamination.

Therefore, in the present embodiment, before dicing, a predetermined groove is ablated along the street St with a laser beam, thereby removing a wiring layer including the low-k film from the street St. The street St is an example of a planned machining line set on the wafer W, which is a workpiece.

### [Overview of machining]

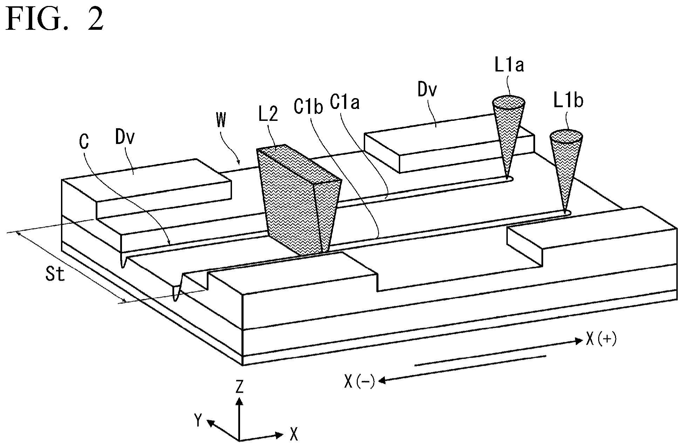

FIG. 2 shows an overview of machining.

As described above, a predetermined groove C is machined along the street St and the wiring layer including the low-k film is removed from the street St. At this time, the groove C is machined in a state in which the process is divided into a machining process of cutting edges on both sides of the groove C and a machining process for cutting the inside the groove C, i.e., a hollowing process. Hereinafter, the machining process for cutting the edges on both sides of the groove C is referred to as an "edge cutting process" and the machining process for cutting the inside of the groove C is referred to as a "hollowing process."

The edge cutting process is performed by radiating a pair of laser beams L1a and L1b along the street St and machining two grooves C1a and C1b parallel to each other along the street St. The two grooves C1a and C1b are machined in the Y direction at an interval corresponding to the width of the groove C to be machined. Moreover, the two grooves C1a and C1b are also machined in the Z direction at a depth corresponding to the depth of the groove C to be machined. Hereinafter, the two grooves C1a and C1b to be machined by this edge cutting process will be referred to as edge cutting grooves C1a and C1b.

The hollowing process is performed by radiating the laser beam L2 having a predetermined machining width between the two edge cutting grooves C1a and C1b. The machining width of the laser beam L2 (a width in a direction perpendicular to a machining progress direction) corresponds to the spacing between the two edge cutting grooves C1a and C1b. A plurality of hollowing processes are executed as necessary.

By combining the edge cutting process and the hollowing process, a single groove C having a predetermined width and depth is finally formed along the street St. The wiring layer including the low-k film from the street St is removed by this groove C. Hereinafter, this groove C is referred to as the wiring layer removal groove C.

If the wiring layer removal groove C is machined using a laser beam of an output that can remove the low-k film all at once, there is a risk that delamination will occur. However, it is possible to suppress the occurrence of delamination by performing a machining process divided into the edge cutting process and the hollowing process as described above.

### [Workpiece machining apparatus]

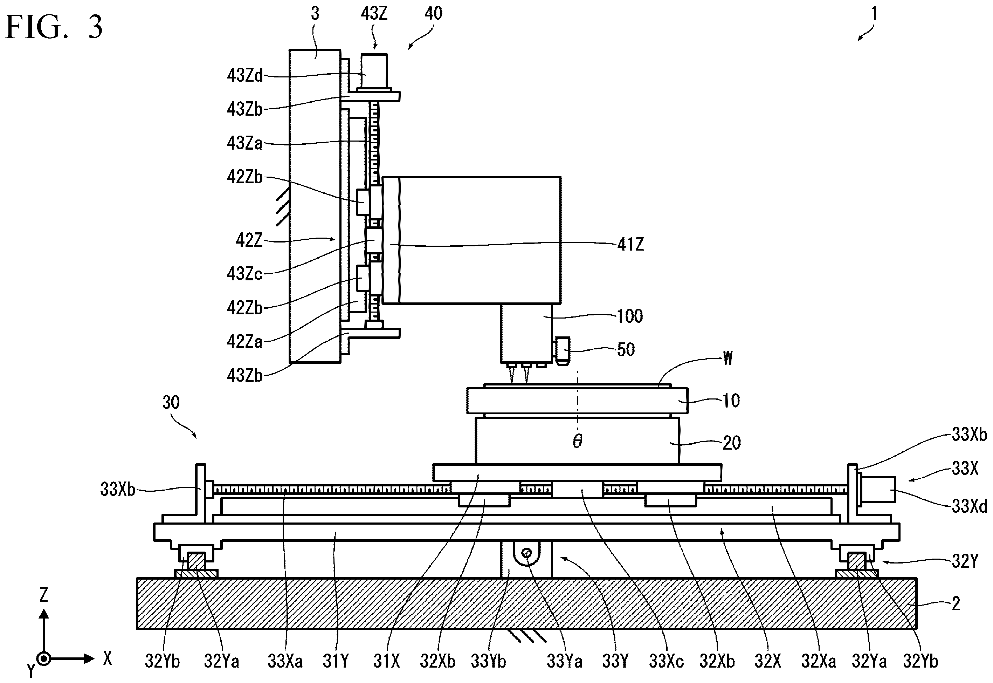

FIG. 3 is a diagram showing a schematic configuration of the workpiece machining apparatus. In FIG. 3, X, Y, and Z are three axes that are perpendicular to one another. In the present embodiment, it is assumed that a plane (an XY plane) including the X and Y axes is a horizontal plane and X and Y directions are horizontal directions. Moreover, it is assumed that a Z direction is a vertical direction (an up-down direction). Moreover, the X direction is a machining feed direction. The machining feed direction is a feed direction when the wiring layer removal groove C is machined. Therefore, the wiring layer removal groove C is machined in the machining feed direction.

As shown in FIG. 3, the workpiece machining apparatus 1 of the present embodiment includes a table 10 configured to hold a wafer W, a table rotation drive unit 20 configured to rotate the table 10, a table feed drive unit 30 configured to feed the table 10 in the X and Y directions, a laser machining head 100 configured to perform ablation machining on the wafer W on the table 10, a head feed drive unit 40 configured to feed the laser machining head 100 in the Z direction, a microscope 50 configured to magnify and observe a surface of the wafer W on the table 10, and the like.

### [Table]

The table 10 has a mounting surface on which the wafer W is placed on an upper surface, and horizontally holds the wafer W on the mounting surface. The table 10 holds the wafer W placed on the mounting surface by suction (for example, vacuum suction). The table 10 includes a tilt mechanism or the like that adjusts the tilt as necessary.

### [Table rotation drive unit]

The table rotation drive unit 20 rotates the table 10 around a θ axis. The θ axis passes through the center of the table 10 and is parallel to the Z axis. The table rotation drive unit 20 has a motor serving as a rotation drive source, a rotation transmission mechanism that transmits the rotation of the motor to the table 10, and the like.

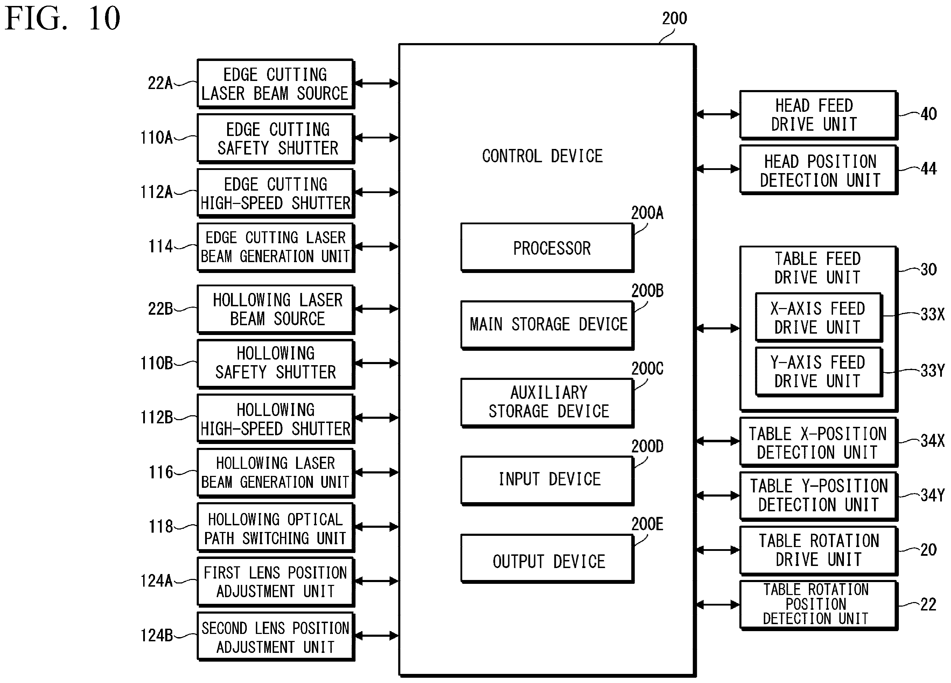

The rotation angle position of the table 10 is detected by a table rotation position detection unit 22 (not shown) (see FIG. 10). The table rotation position detection unit 22 includes, for example, a rotary encoder and the like.

### [Table feed drive unit]

The table feed drive unit 30 relatively moves the table 10 in the X and Y directions with respect to the laser machining head 100 and feeds the table 10 in the X and Y directions. In the present embodiment, the table feed drive unit 30 is an example of a feed drive unit.

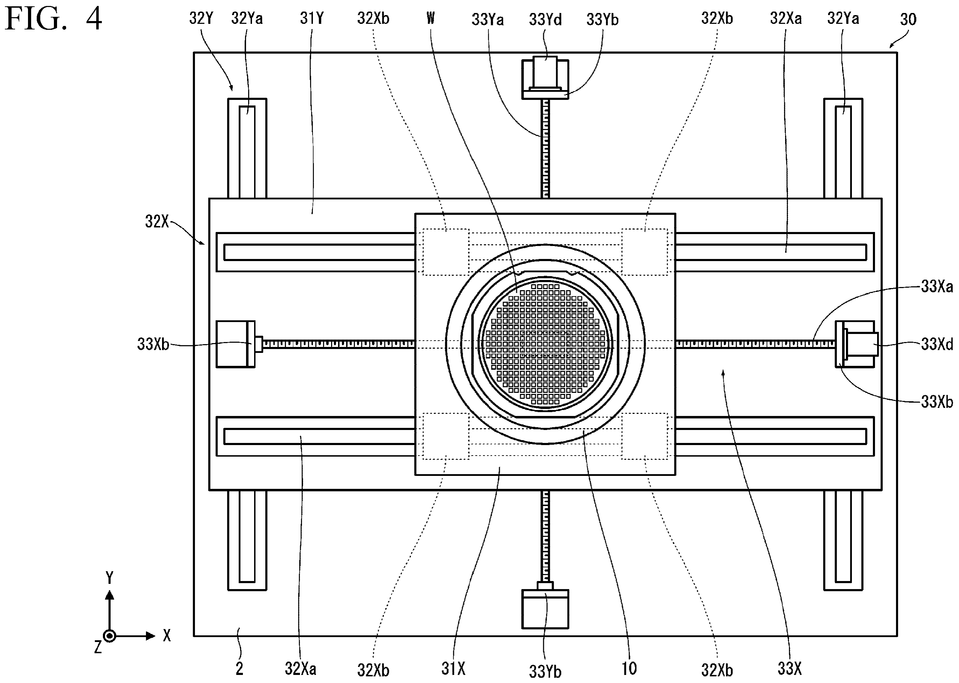

FIG. 4 is a plan view showing a schematic configuration of the table feed drive unit.

As shown in FIGS. 3 and 4, the table feed drive unit 30 includes a Y-axis stage 31Y that moves in the Y direction on the base 2 horizontally provided, a Y-axis guide unit 32Y that guides the Y-axis stage 31Y to move in the Y direction, a Y-axis drive mechanism 33Y that applies a feed operation to the Y-axis stage 31Y in the Y direction, an X-axis stage 31X that moves on the Y-axis stage 31Y in the X direction, an X-axis guide unit 32X that guides the X-axis stage 31X to move in the X direction, an X-axis drive mechanism 33X that applies a feed operation to the X-axis stage 31X in the X direction, and the like. The table 10 is mounted on the X-axis stage 31X and is fed in the X and Y directions.

The Y-axis stage 31Y has a flat plate shape and is arranged parallel to the XY plane. The Y-axis stage 31Y moves in the Y direction within the XY plane.

The Y-axis guide unit 32Y includes a guide rail 32Ya laid in the Y direction, a slider 32Yb that slides on the guide rail 32Ya, and the like. The guide rail 32Ya is laid on the base 2. The Y-axis stage 31Y is supported slidably on the guide rail 32Ya via the slider 32Yb.

The Y-axis drive mechanism 33Y includes, for example, a feed screw mechanism, and has a screw shaft 33Ya, a bearing 33Yb, a nut 33Yc, a Y-axis motor 33Yd, and the like. The screw shaft 33Ya is arranged in the Y direction. The bearing 33Yb is provided on the base 2 and rotatably supports the screw shaft 33Ya on the base 2. The nut 33Yc is screwed to the screw shaft 33Ya and fixed to the Y-axis stage 31Y. The Y-axis motor 33Yd rotates the screw shaft 33Ya around its axis. By rotating the screw shaft 33Ya with the Y-axis motor 33Yd, the Y-axis stage 31Y moves in the Y direction on the base 2.

The X-axis stage 31X has a flat plate shape and is arranged parallel to the XY plane. The X-axis stage 31X moves in the X direction within the XY plane.

The X-axis guide unit 32X includes a guide rail 32Xa laid in the X direction, and a slider 32Xb that slides on the guide rail 32Xa. The guide rail 32Xa is laid on the Y-axis stage 31Y that is horizontal. The X-axis stage 31X is supported slidably on the guide rail 32Xa via the slider 32Xb.

The X-axis drive mechanism 33X is, for example, a feed screw mechanism, and includes a screw shaft 33Xa, a bearing 33Xb, a nut 33Xc, an X-axis motor 33Xd, and the like. The screw shaft 33Xa is arranged along the X direction. The bearing 33Xb is provided on the Y-axis stage 31Y, and supports the screw shaft 33Xa rotatably on the Y-axis stage 31Y. The nut 33Xc is screwed to the screw shaft 33Xa and is fixed to the X-axis stage 31X. The X-axis motor 33Xd rotates the screw shaft 33Xa around its axis. By rotating the screw shaft 33Xa with the X-axis motor 33Xd, the X-axis stage 31X moves on the Y-axis stage 31Y in the X direction.

With the table feed drive unit 30 configured as described above, the table 10 is fed in the Y direction by moving the Y-axis stage 31Y in the Y direction using the Y-axis drive mechanism 33Y. Moreover, the table 10 is fed in the X direction (a machining feed direction) by moving the X-axis stage 31X in the X direction using the X-axis drive mechanism 33X.

The position of the table 10 in the X direction is detected by a table X-position detection unit 34X (not shown) (see FIG. 10). As an example, the position in the X direction relative to the origin is detected. Moreover, the position in the Y direction is detected by a table Y-position detection unit 34Y (not shown) (see FIG. 10). As an example, the position in the Y direction relative to the origin is detected. The table X-position detection unit 34X and the table Y-position detection unit 34Y are configured, for example, with linear scales or the like.

### [Laser machining head]

The laser machining head 100 machines two grooves (edge cutting grooves) by radiating a pair of laser beams onto the wafer W on the table 10 fed in the machining feed operation (an edge cutting process). Moreover, the laser machining head 100 hollows out an area between the two grooves by radiating a laser beam between the two grooves to which the edge cutting process has been applied. In the present embodiment, the laser machining head 100 is an example of a machining unit. Details of the laser machining head 100 will be described below.

### [Head feed drive unit]

As shown in FIG. 3, the head feed drive unit 40 has a Z-axis stage 41Z that moves in the Z direction on the column 3, a Z-axis guide unit 42Z that guides the Z-axis stage 41Z to move in the Z direction, a Z-axis drive mechanism 43Z that feeds the Z-axis stage 41Z in the Z direction, and the like. The column 3 is provided perpendicular to the base 2. The laser machining head 100 is mounted on the Z-axis stage 41Z and fed in the Z direction.

The Z-axis stage 41Z has a flat plate shape and is arranged parallel to a ZY plane. The Z-axis stage 41Z moves in the Z direction within the ZY plane.

The Z-axis guide unit 42Z includes a guide rail 42Za laid in the Z direction, and a slider 42Zb that slides on the guide rail 42Za. The guide rail 42Za is laid on the column 3. The Z-axis stage 41Z is supported slidably on the guide rail 42Za via the slider 42Zb.

The Z-axis drive mechanism 43Z includes, for example, a feed screw mechanism, and has a screw shaft 43Za, a bearing 43Zb, a nut 43Zc, and a Z-axis motor 43Zd. The screw shaft 43Za is arranged in the Z direction. The bearing 43Zb is provided on the column 3 and rotatably supports the screw shaft 43Za on the column 3. The nut 43Zc is screwed to the screw shaft 43Za and fixed to the Z-axis stage 41Z. The Z-axis motor 43Zd rotates the screw shaft 43Za around its axis. By rotating the screw shaft 43Za with the Z-axis motor 43Zd, the Z-axis stage 41Z moves on the column 3 in the Z direction.

With the head feed drive unit 40 configured as described above, the Z-axis drive mechanism 43Z moves the Z-axis stage 41Z in the Z direction, thereby feeding the laser machining head 100 in the Z direction. The position of the laser machining head 100 in the Z direction (as an example, the position in the Z direction relative to the origin) is detected by the head position detection unit 44 (not shown). The head position detection unit 44 is configured, for example, with linear scales or the like.

### [Microscope]

The microscope 50 is mounted on the Z-axis stage 41Z together with the laser machining head 100. Therefore, it moves in the Z direction together with the laser machining head 100. The microscope 50 captures an image magnified by an optical system with an image sensor and outputs the image. The image captured by the microscope 50 is used for alignment, kerf checking, or the like.

### [Laser machining head]

As described above, the laser machining head 100 machines two grooves by radiating a pair of laser beams onto the wafer W on the table 10 fed in the machining feed operation. Moreover, a laser beam is radiated between the two grooves to hollow out the area between the two grooves.

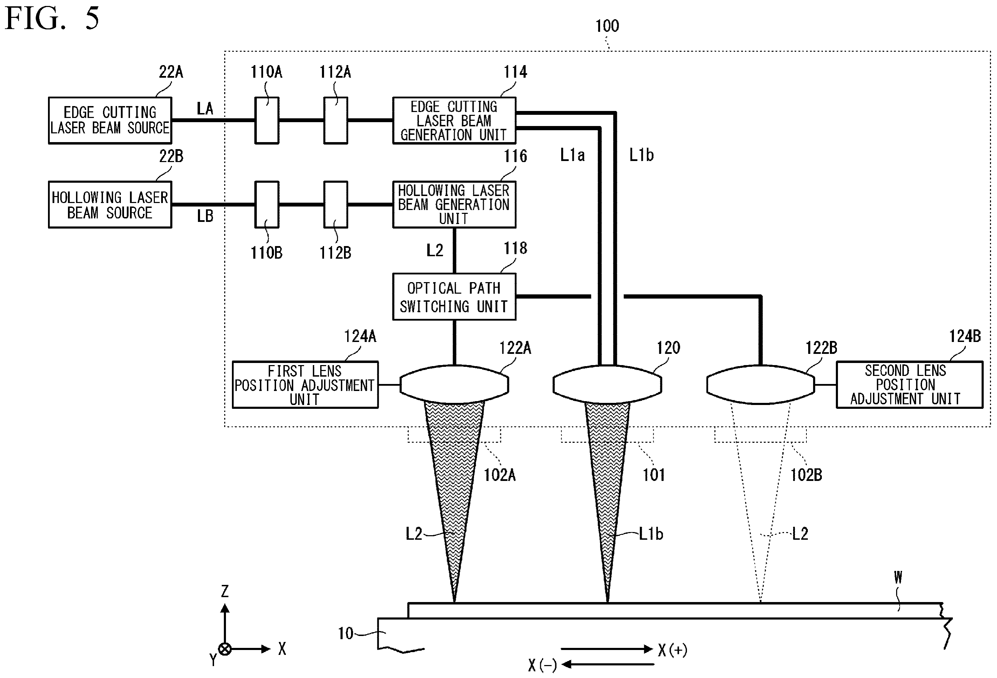

FIG. 5 is a diagram showing the schematic configuration of the laser machining head.

As shown in FIG. 5, the laser machining head 100 includes an edge cutting safety shutter 110A, a hollowing safety shutter 110B, an edge cutting high-speed shutter 112A, a hollowing high-speed shutter 112B, an edge cutting laser beam generation unit 114, a hollowing laser beam generation unit 116, a hollowing optical path switching unit 118, an edge cutting condenser lens 120, a first hollowing condenser lens 122A, a second hollowing condenser lens 122B, a first lens position adjustment unit 124A, a second lens position adjustment unit 124B, and the like.

The edge cutting safety shutter 110A, the edge cutting high-speed shutter 112A, the edge cutting laser beam generation unit 114, and the edge cutting condenser lens 120 constitute a laser optical system for the edge cutting process.

Moreover, the hollowing safety shutter 110B, the hollowing high-speed shutter 112B, the hollowing laser beam generation unit 116, the hollowing optical path switching unit 118, the first hollowing condenser lens 122A, the second hollowing condenser lens 122B, the first lens position adjustment unit 124A, and the second lens position adjustment unit 124B constitute a hollowing laser optical system.

### [Laser optical system for edge cutting process]

As described above, the edge cutting safety shutter 110A, the edge cutting high-speed shutter 112A, the edge cutting laser beam generation unit 114, and the edge cutting condenser lens 120 constitute a laser optical system for the edge cutting process. The laser optical system for the edge cutting process generates a pair of laser beams L1a and L1b (hereinafter referred to as edge cutting laser beams L1a and L1b) from the laser beam LA supplied from the edge cutting laser beam source 22A, and emits the pair of laser beams L1a and L1b from the edge cutting emission port 101 via the edge cutting condenser lens 120.

The edge cutting laser beam source 22A supplies pulsed laser beams to the laser machining head 100 under conditions suitable for the edge cutting process, for example, conditions obtained by adjusting a wavelength, a pulse width, a repetition frequency, and the like.

The edge cutting safety shutter 110A is arranged on the optical path of the laser beam LA supplied from the edge cutting laser beam source 22A, and opens and closes the optical path. By closing the edge cutting safety shutter 110A, the incidence of the laser beam LA supplied from the edge cutting laser beam source 22A is blocked.

The edge cutting high-speed shutter 112A is arranged on the optical path of the laser beam LA passing through the edge cutting safety shutter 110A and opens and closes the optical path. The edge cutting high-speed shutter 112A includes a shutter that operates at a higher speed than the edge cutting safety shutter 110A. The edge cutting high-speed shutter 112A is primarily used to temporarily stop the emission of the edge cutting laser beams L1a and L1b. In other words, while the edge cutting safety shutter 110A safely and reliably blocks the incidence of the laser beam LA, the edge cutting high-speed shutter 112A prioritizes its operating speed and functions as a means for instantly turning on and off the emission of the edge cutting laser beams L1a and L1b.

The edge cutting laser beam generation unit 114 generates a pair of edge cutting laser beams L1a and L1b for the edge cutting process from the laser beam LA supplied from the edge cutting laser beam source 22A.

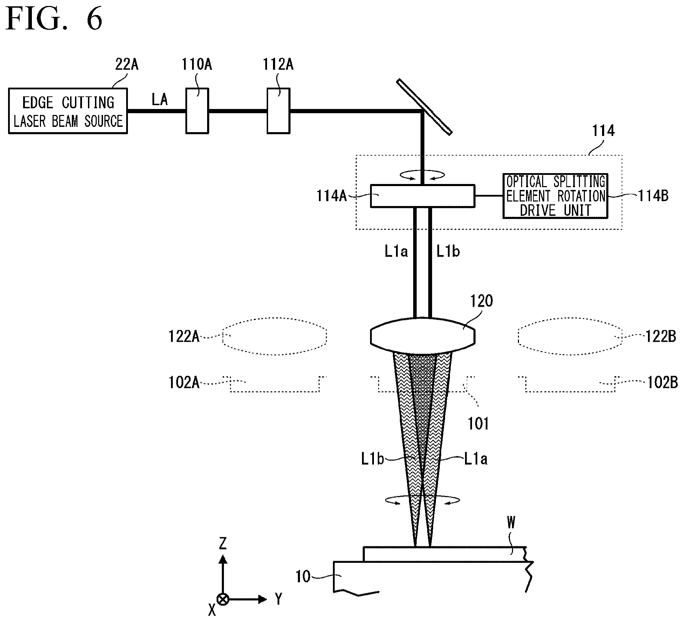

FIG. 6 is a diagram showing an example of a configuration of the edge cutting laser beam generation unit.

As shown in FIG. 6, the edge cutting laser beam generation unit 114 has an optical splitting element 114A and an optical splitting element rotation drive unit 114B.

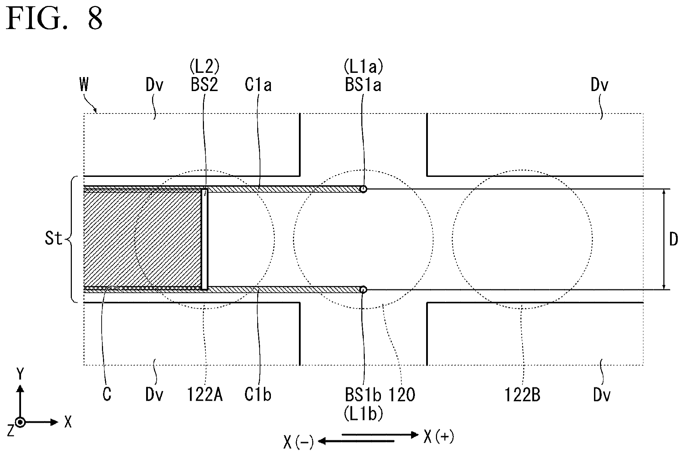

The optical splitting element 114A splits the incident light (the laser beam LA) into two to generate a pair of edge cutting laser beams L1a and L1b. The optical splitting element 114A includes, for example, a diffractive optical element (DOE). The diffractive optical element is an optical element that can spatially split the laser beam using the diffraction phenomenon of light. The diffractive optical element can change the laser beam in various patterns and shapes. In the present embodiment, the optical splitting element 114A splits the incident light into two axially symmetrically with respect to the optical axis of the edge cutting condenser lens 120 to generate the pair of edge cutting laser beams L1a and L1b. Therefore, the pair of edge cutting laser beams L1a and L1b emitted through the edge cutting condenser lens 120 are emitted axially symmetrically with respect to the optical axis of the edge cutting condenser lens 120. Therefore, beam spots BS1a and BS1b are also radiated axially symmetrically with respect to the optical axis of the edge cutting condenser lens 120 (see FIG. 8). In addition to the diffractive optical element, the optical splitting element 114A can also employ a refractive optical element (ROE), a Wollaston prism, or the like.

The optical splitting element rotation drive unit 114B has an actuator and rotates the optical splitting element 114A around the optical axis of the incident light. By rotating the optical splitting element 114A, the beam spots BS1a and BS1b of the pair of edge cutting laser beams L1a and L1b radiated onto the wafer W rotate. The beam spots rotate around the optical axis of the edge cutting condenser lens 120. As a result, the interval D between the beam spots BS1a and BS1b (the interval in the direction (the Y direction) perpendicular to the machining feed direction (the X direction)) changes (see FIG. 8). Therefore, when the optical splitting element 114A is rotated, the interval between the edge cutting grooves C1a and C1b to be machined can be adjusted.

In this way, the edge cutting laser beam generation unit 114 of the present embodiment has a function of adjusting the interval between the pair of edge cutting laser beams L1a and L1b (the interval in the direction perpendicular to the machining feed direction) in addition to the function of generating the pair of edge cutting laser beams L1a and L1b. The edge cutting laser beam generation unit 114 may further include a means for adjusting intensities of the edge cutting laser beams L1a and L1b (an intensity modulation means) or the like. For example, an acoustic optical deflector (AOD) or the like may be included as the intensity modulation means.

The pair of edge cutting laser beams L1a and L1b generated by the edge cutting laser beam generation unit 114 are radiated from the edge cutting emission port 101 to the wafer W on the table 10 via the edge cutting condenser lens 120.

The edge cutting condenser lens 120 condenses the pair of edge cutting laser beams L1a and L1b generated by the edge cutting laser beam generation unit 114 at a predetermined position (focus) in the Z direction and radiates the pair of edge cutting laser beams L1a and L1b to the wafer W on the table 10. An irradiation direction is vertically downward (downward in the Z direction).

The pair of edge cutting laser beams L1a and L1b are an example of a pair of first laser beams. Moreover, the edge cutting condenser lens 120 is an example of a first machining unit.

### [Laser optical system for hollowing process]

As described above, the hollowing safety shutter 110B, the hollowing high-speed shutter 112B, the hollowing laser beam generation unit 116, the hollowing optical path switching unit 118, the first hollowing condenser lens 122A, the second hollowing condenser lens 122B, the first lens position adjustment unit 124A, and the second lens position adjustment unit 124B constitute a laser optical system for the hollowing process.

The laser optical system for the hollowing process generates a laser beam L2 for hollowing (hereinafter referred to as a hollowing laser beam L2) from a laser beam LB supplied from the hollowing laser beam source 22B and emits the laser beam L2 from the first hollowing emission port 102A or the second hollowing emission port 102B via the first hollowing condenser lens 122A or the second hollowing condenser lens 122B.

The hollowing laser beam source 22B supplies a pulsed laser beam to the laser machining head 100 under conditions suitable for the hollowing process, for example, conditions obtained by adjusting a wavelength, a pulse width, a repetition frequency, and the like. Moreover, the hollowing laser beam source 22B supplies a linearly polarized laser beam LB polarized in a predetermined polarization direction.

The hollowing safety shutter 110B is arranged on the optical path of the laser beam LB supplied from hollowing laser beam source 22B and opens and closes the optical path. When the hollowing safety shutter 110B is closed, the incidence of the laser beam LB supplied from the hollowing laser beam source 22B is blocked.

The hollowing high-speed shutter 112B is arranged on the optical path of the laser beam LB passing through the hollowing safety shutter 110B and opens and closes the optical path. The hollowing high-speed shutter 112B includes a shutter that operates at a higher speed than the hollowing safety shutter 110B. The hollowing high-speed shutter 112B is mainly used to temporarily stop the emission of the hollowing laser beam L2. In other words, while the hollowing safety shutter 110B safely and reliably blocks the incidence of the laser beam LB, the hollowing high-speed shutter 112B prioritizes its operating speed and functions as a means for instantly turning on and off the emission of the hollowing laser beam L2.

The hollowing laser beam generation unit 116 generates the hollowing laser beam L2 from the laser beam LB supplied from the hollowing laser beam source 22B. In the present embodiment, a laser beam with a rectangular beam spot BS2 is generated as the hollowing laser beam L2 (see FIG. 8).

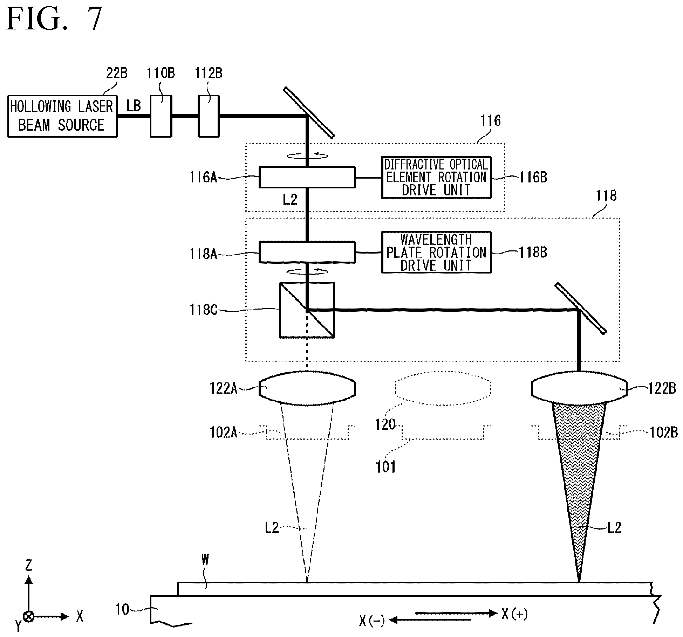

FIG. 7 is a diagram showing an example of configurations of the hollowing laser beam generation unit and the hollowing optical path switching unit.

As shown in FIG. 7, the hollowing laser beam generation unit 116 has a diffractive optical element (DOE) 116A and a diffractive optical element rotation drive unit 116B.

As described above, the diffractive optical element 116A has the function of changing the laser beam in various patterns and shapes. In the present embodiment, the shape (beam spot shape) of the laser beam emitted as the hollowing laser beam L2 is changed to a rectangular shape.

The diffractive optical element rotation drive unit 116B has an actuator and rotates the diffractive optical element 116A around the optical axis of the incident light. By rotating the diffractive optical element 116A, the beam spot BS2 of the hollowing laser beam L2 radiated onto the wafer W rotates. The beam spot BS2 rotates around the optical axis of the first hollowing condenser lens 122A or the second hollowing condenser lens 122B. As a result, the width of the beam spot in the direction perpendicular to the machining feed direction changes. In other words, the machining width changes. Therefore, the machining width can be adjusted by rotating the diffractive optical element 116A.

In this way, the hollowing laser beam generation unit 116 of the present embodiment has a function of adjusting the machining width in addition to the function of generating the hollowing laser beam L2. In addition, the hollowing laser beam generation unit 116 may include a means for adjusting an intensity of the hollowing laser beam L2, a means for adjusting an intensity distribution, and the like. Examples of the means for adjusting the intensity of the hollowing laser beam L2 include an acoustic optical element and the like. In particular, it is preferable to make the intensity distribution in a top hat shape (also referred to as a flat top). When the intensity distribution of the hollowing laser beam L2 has a top hat shape, the bottom surface of the groove to which the hollowing process is applied can be machined flatly. For example, a diffractive optical element (DOE), a refractive beam shaper, or the like may be adopted as a means for converting the intensity distribution into a top hat shape.

The hollowing optical path switching unit 118 switches the optical path of the hollowing laser beam L2 generated by the hollowing laser beam generation unit 116 to the first optical path or the second optical path. The first optical path is an optical path along which the hollowing laser beam L2 is guided to the first hollowing condenser lens 122A. On the other hand, the second optical path is an optical path along which the hollowing laser beam L2 is guided to the second hollowing condenser lens 122B.

As shown in FIG. 7, the hollowing optical path switching unit 118 has a 1/2 wavelength plate (1/2λ plate) 118A, a wavelength plate rotation drive unit 118B, a polarizing beam splitter 118C, and the like.

The 1/2 wavelength plate 118A is arranged on the optical path of the hollowing laser beam L2 emitted from the hollowing laser beam generation unit 116. As described above, the hollowing laser beam source 22B supplies a linearly polarized laser beam LB polarized in a predetermined polarization direction. Therefore, the hollowing laser beam L2 emitted from the hollowing laser beam generation unit 116 also includes a linearly polarized laser beam polarized in the predetermined polarization direction. Therefore, when the 1/2 wavelength plate 118A is rotated, the polarization direction of the hollowing laser beam L2 changes.

The wavelength plate rotation drive unit 118B rotates the 1/2 wavelength plate 118A between a first position and a second position. The second position is a position rotated 45° from the first position. When the 1/2 wavelength plate 118A is rotated from the first position to the second position, the polarization direction of the hollowing laser beam L2 rotates 90°. When the 1/2 wavelength plate 118A is set at the first position, the hollowing laser beam L2 polarized in the first polarization direction is emitted from the 1/2 wavelength plate 118A. On the other hand, when the 1/2 wavelength plate 118A is set at the second position, the hollowing laser beam L2 polarized in the second polarization direction is emitted from the 1/2 wavelength plate 118A. The second polarization direction is perpendicular to the first polarization direction.

The polarizing beam splitter 118C is arranged on the optical path of the hollowing laser beam L2 that has passed through the 1/2 wavelength plate 118A. The polarizing beam splitter 118C splits the incident light into transmitted light and reflected light in accordance with the polarization state of the incident light. When light polarized in a first polarization direction is incident on the polarizing beam splitter 118C, the polarizing beam splitter 118C transmits the light. When light polarized in a second polarization direction is incident on the polarizing beam splitter 118C, the polarizing beam splitter 118C reflects the light.

As described above, when the 1/2 wavelength plate 118A is set at the first position, the hollowing laser beam L2 polarized in the first polarization direction is emitted from the 1/2 wavelength plate 118A. Therefore, if the 1/2 wavelength plate 118A is set at the first position, the hollowing laser beam L2 is transmitted through the polarizing beam splitter 118C.

On the other hand, when the 1/2 wavelength plate 118A is set at the second position, the hollowing laser beam L2 polarized in the second polarization direction is emitted from the 1/2 wavelength plate 118A. Therefore, when the 1/2 wavelength plate 118A is set at the second position, the hollowing laser beam L2 is reflected by the polarizing beam splitter 118C.

The laser beam transmitted through the polarizing beam splitter 118C is emitted from the first hollowing emission port 102A via the first hollowing condenser lens 122A. On the other hand, the laser beam reflected by the polarizing beam splitter 118C is emitted from the second hollowing emission port 102B via the second hollowing condenser lens 122B.

In this way, the hollowing optical path switching unit 118 can switch the emission port between the first hollowing emission port 102A and the second hollowing emission port 102B, which emit the hollowing laser beams L2. Moreover, at the same time, the condenser lens can be switched between the first hollowing condenser lens 122A and the second hollowing condenser lens 122B, which perform the emission process.

The first hollowing condenser lens 122A and the second hollowing condenser lens 122B each condense the hollowing laser beam L2 generated by the hollowing laser beam generation unit 116 at a predetermined position (focus) in the Z direction. The irradiation direction is vertically downward (downward in the Z direction).

The hollowing laser beam L2 is an example of a second laser beam. Moreover, each of the first hollowing condenser lens 122A and the second hollowing condenser lens 122B is an example of a second machining unit.

FIG. 8 is a conceptual diagram of laser beam irradiation.

As shown in FIG. 8, a pair of edge cutting laser beams L1a and L1b are used to machine two edge cutting grooves C1a and C1b in the wafer W. Also, the hollowing laser beam L2 is radiated between the two edge cutting grooves C1a and C1b that have been machined and the hollowing process is performed between the two edge cutting grooves C1a and C1b.

In the laser machining head 100 of the present embodiment, the first hollowing condenser lens 122A and the second hollowing condenser lens 122B are arranged in front of and behind the edge cutting condenser lens 120 in the machining feed direction (the X direction) in a state in which the edge cutting condenser lens 120 is sandwiched therebetween.

Thereby, the hollowing process can be performed on both the forward and return paths when the wafer W is moved back and forth in the machining feed direction. For example, in FIG. 1, if the X (-) direction is the forward feed direction and the X (+) direction is the return feed direction, the hollowing process is performed by emitting the hollowing laser beam L2 from the first hollowing condenser lens 122A along the forward path. On the other hand, the hollowing process is performed by emitting the hollowing laser beam L2 from the second hollowing condenser lens 122B along the return path.

The first lens position adjustment unit 124A adjusts the position of the first hollowing condenser lens 122A. Moreover, the second lens position adjustment unit 124B adjusts the position of the second hollowing condenser lens 122B. The first lens position adjustment unit 124A moves (shifts) the first hollowing condenser lens 122A in the Y direction within the XY plane to adjust its position. Likewise, the second lens position adjustment unit 124B moves the second hollowing condenser lens 122B in the Y direction within the XY plane to adjust its position. That is, the first lens position adjustment unit 124A and the second lens position adjustment unit 124B adjust the positions of the first hollowing condenser lens 122A and the second hollowing condenser lens 122B in the Y direction, respectively.

In this way, because the positions of the first hollowing condenser lens 122A and the second hollowing condenser lens 122B are adjusted by the first lens position adjustment unit 124A and the second lens position adjustment unit 124B, respectively, the first hollowing condenser lens 122A and the second hollowing condenser lens 122B are provided to be movable (so that their positions are adjustable) in the Y direction. The first lens position adjustment unit 124A and the second lens position adjustment unit 124B have actuators that move the first lens position adjustment unit 124A and the second lens position adjustment unit 124B in the Y direction. The type of actuator is not particularly limited. It is only necessary to move the first lens position adjustment unit 124A and the second lens position adjustment unit 124B within a required movement range.

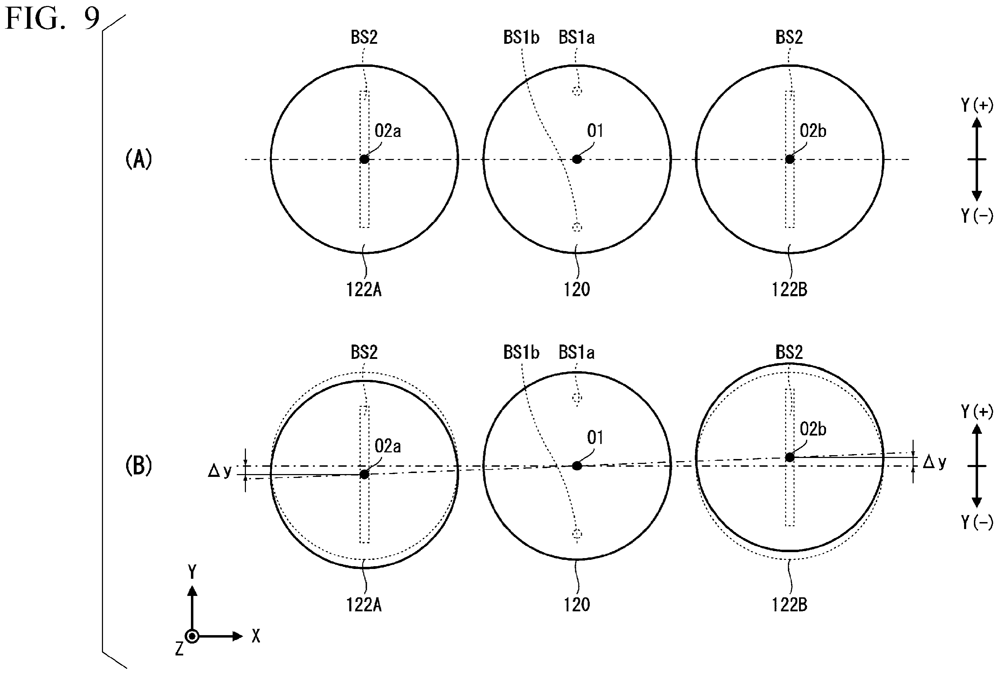

FIG. 9 is a conceptual diagram of position adjustment. In FIG. 9, (A) shows an unadjusted state and (B) shows an adjusted state.

As shown in FIG. 9(A), in the unadjusted state, the edge cutting condenser lens 120, the first hollowing condenser lens 122A, and the second hollowing condenser lens 122B are arranged in a row at equal intervals in the X direction. Therefore, an array direction of the three condenser lenses described above (an array direction of the optical axis) coincides with the X direction. It is assumed that this array state is a reference array state.

FIG. 9(B) shows an example in which the first hollowing condenser lens 122A and the second hollowing condenser lens 122B are moved by equal amounts in opposite directions from the reference arrangement state. Specifically, an example in which the first hollowing condenser lens 122A is moved by Δy in the Y (-) direction and the second hollowing condenser lens 122B is moved by Δy in the Y (+) direction is shown.

In this way, it is possible to adjust the tilt of the array of the three condenser lenses in the X direction by moving the first hollowing condenser lens 122A and the second hollowing condenser lens 122B in the Y direction.

Thereby, it is possible to correct any misalignment in a case where the misalignment occurs between the movement direction of the table 10 (the machining feed direction) and the array direction of the three condenser lenses and the like. That is, it is possible to perform a correction process so that the three condenser lenses are arrayed in a movement direction of the table 10. This point will be described below.

### [Electrical configuration of workpiece machining apparatus]

FIG. 10 is a block diagram showing an example of an electrical configuration of the workpiece machining apparatus.

As shown in FIG. 10, the operation of each part constituting the workpiece machining apparatus 1 is controlled by the control device 200.

The control device 200 includes, for example, a computer including a processor 200A, a main storage device 200B, an auxiliary storage device 200C, an input device 200D, an output device 200E, and the like. That is, the computer functions as the control device 200 by executing a predetermined program. The processor 200A includes, for example, a central processing unit (CPU). The main storage device 200B includes, for example, a random-access memory (RAM). The auxiliary storage device 200C includes, for example, a hard disk drive (HDD), a solid-state drive (SSD), and the like. The input device 200D includes operation buttons, a keyboard, a touch panel, and the like. The output device 200E is, for example, a display (a display device). The input device 200D and the output device 200E may be configured as a touch panel display.

The control device 200 controls ON and OFF of the edge cutting laser beam source 22A and also controls the intensity of the laser beam LA to be supplied or the like.

The control device 200 controls the opening and closing of the edge cutting safety shutter 110A and the edge cutting high-speed shutter 112A.

In the edge cutting laser beam generation unit 114, the driving of the optical splitting element rotation drive unit 114B is controlled by the control device 200 and the rotation of the optical splitting element 114A is controlled thereby.

The control device 200 controls ON and OFF of the hollowing laser beam source 22B and also controls the intensity of the laser beam LB to be supplied or the like.

The control device 200 controls opening and closing of the hollowing safety shutter 110B and the hollowing high-speed shutter 112B.

In the hollowing laser beam generation unit 116, the driving of the diffractive optical element rotation drive unit 116B is controlled by the control device 200, and the rotation of the diffractive optical element 116A is controlled thereby.

In the hollowing optical path switching unit 118, the drive of the wavelength plate rotation drive unit 118B is controlled by the control device 200, and the rotation of the 1/2 wavelength plate 118A is controlled thereby.

In the first lens position adjustment unit 124A and the second lens position adjustment unit 124B, the driving of their actuators is controlled by the control device 200.

The control device 200 controls the driving of the head feed drive unit 40 and controls the feed operation in the Z direction applied to the laser machining head 100.

The head position detection unit 44 detects a position of the laser machining head 100 in the Z direction and outputs information about the detected position to the control device 200.

The driving of the table feed drive unit 30 is controlled by the control device 200 and the feed operation applied to the table 10 in the X and Y directions is controlled. More specifically, the control device 200 controls the X-axis drive mechanism 33X and controls the feed operation applied to the table 10 in the X direction. Moreover, the control device 200 controls the Y-axis drive mechanism 33Y and controls the feed operation applied to the table 10 in the Y direction.

The table X-position detection unit 34X detects the position of the table 10 in the X direction and outputs information about the detected position to the control device 200.

The table Y-position detection unit 34Y detects the position of the table 10 in the Y direction and outputs information about the detected position to the control device 200.

The driving of the table rotation drive unit 20 is controlled by the control device 200, and the rotation around θ to be applied to the table 10 is controlled.

The table rotation position detection unit 22 detects a rotation angle position of the table 10 and outputs information about the detected rotation angle position to the control device 200.

### [Function of workpiece machining apparatus]

### [Machining of workpiece (wafer)]

As described above, a wiring layer removal groove C is machined along the street St for a wafer W having a low-k film, thereby removing the wiring layer including the low-k film from the street St.

The workpiece machining apparatus 1 machines the wiring layer removal groove C along the street St by moving the table 10 in the machining feed direction while radiating the pair of edge cutting laser beams L1a and L1b and the hollowing laser beam L2 from the laser machining head 100 to the wafer W on the table 10.

In the workpiece machining apparatus 1 of the present embodiment, when the emission port is switched between the first and second hollowing emission ports 102A and 102B, which are the emission ports of the hollowing laser beam L2, the wiring layer removal groove C is machined in the wafer W along both the forward and return paths in the machining feed operation.

Specifically, in FIG. 1, if a direction in which the table 10 is fed in the X (-) direction is defined as the forward path and a direction in which the table 10 is fed in the X (+) direction is defined as the return path, the hollowing laser beam L2 is emitted from the first hollowing emission port 102A to machine the wiring layer removal groove C along the forward path. On the other hand, the hollowing laser beam L2 is emitted from the second hollowing emission port 102B to machine the wiring layer removal groove C along the return path. In other words, the hollowing laser beam L2 is always emitted from the emission port positioned on the downstream side in a machining progress direction of the table 10 to machine the wiring layer removal groove C. The machining progress direction of the forward path is the X (+) direction in FIG. 1. Moreover, the machining progress direction of the return path is the X (-) direction in FIG. 1. In other words, machining progresses in a direction opposite to the feed direction of the wafer W.

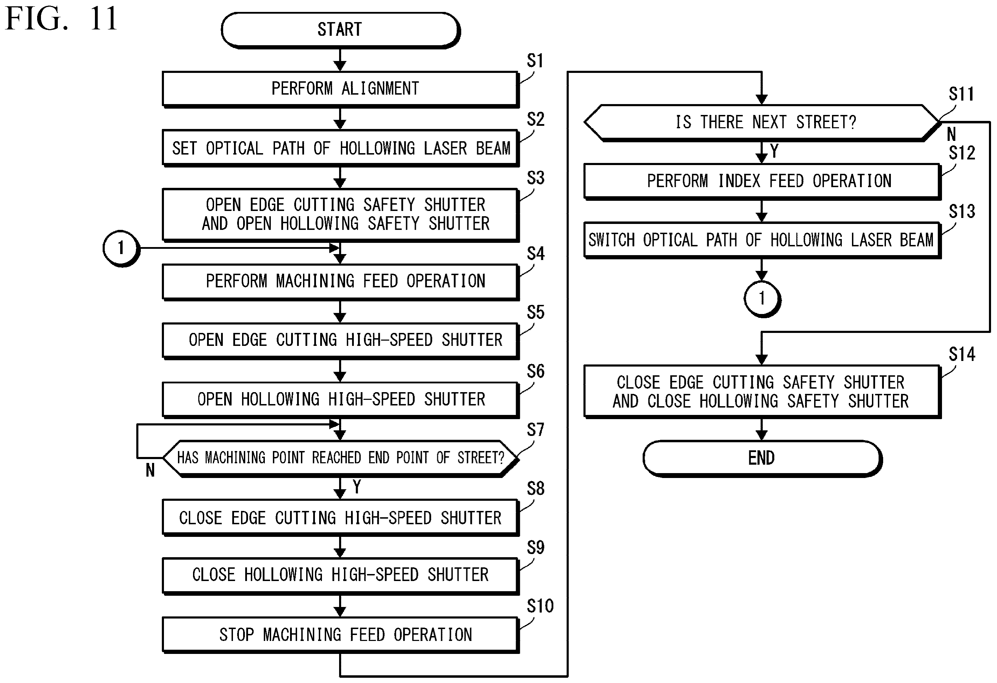

FIG. 11 is a flowchart showing a flow of a machining process.

In addition, it is assumed that the wafer W is held on the table 10, and the laser beams LA and LB are supplied to the laser machining head 100 from the edge cutting laser beam source 22A and the hollowing laser beam source 22B. Moreover, it is assumed that the edge cutting safety shutter 110A and the hollowing safety shutter 110B as well as the edge cutting high-speed shutter 112A and the hollowing high-speed shutter 112B are closed.

First, alignment is performed (step S1). That is, the machining position is detected and aligned. The alignment is performed on the basis of an image captured by the microscope 50. According to the alignment, the optical axis of the edge cutting condenser lens 120 is positioned at a machining start position of the street St.

Subsequently, the optical path of the hollowing laser beam L2 is set (step S2). As described above, the hollowing laser beam L2 is emitted from the first hollowing emission port 102A to perform the hollowing process along the forward path. On the other hand, the hollowing laser beam L2 is emitted from the second hollowing emission port 102B to perform the hollowing process along the return path. Therefore, a first optical path along which the hollowing laser beam L2 is emitted from the first hollowing emission port 102A is set in the machining on the forward path. Moreover, a second optical path in which the hollowing laser beam L2 is emitted from the second hollowing emission port 102B is set in the machining on the return path.

Here, it is assumed that initial machining is started according to a feed operation on the forward path (a feed operation in the X (-) direction). Therefore, the first optical path along which the hollowing laser beam L2 is emitted from the first hollowing emission port 102A is set.

After the optical path of the hollowing laser beam L2 is set, the edge cutting safety shutter 110A and the hollowing safety shutter 110B are opened (step S3). Thereby, the laser beam LA supplied from the edge cutting laser beam source 22A and the laser beam LB supplied from the hollowing laser beam source 22B are introduced into the laser machining head 100. However, because the edge cutting high-speed shutter 112A and the hollowing high-speed shutter 112B are closed, the laser beam is not emitted from each emission port.

Subsequently, a machining feed operation is started (step S4). That is, the X-axis stage 31X is driven and the machining feed operation is applied to the table 10.

Subsequently, the edge cutting high-speed shutter 112A is opened (step S5). Thereby, a pair of edge cutting laser beams L1a and L1b are radiated toward the wafer W on the table 10. The pair of edge cutting laser beams L1a and L1b are emitted from the edge cutting emission port 101. Thereby, the machining of two edge cutting grooves C1a and C1b along the street St is started.

Subsequently, the hollowing high-speed shutter 112B is opened (step S6). Thereby, the hollowing laser beam L2 is radiated toward the wafer W on the table 10. The hollowing laser beam L2 is emitted from the first hollowing emission port 102A or the second hollowing emission port 102B. The hollowing laser beam L2 is emitted from the first hollowing emission port 102A via the first hollowing condenser lens 122A along the forward path. On the other hand, the hollowing laser beam L2 is emitted from the second hollowing emission port 102B via the second hollowing condenser lens 122B along the return path. The emitted hollowing laser beam L2 is radiated between the two edge cutting grooves C1a and C1b that have been machined in advance. Thereby, the hollowing process is performed between the two edge cutting grooves C1a and C1b. When the hollowing process is performed between the two edge cutting grooves C1a and C1b, one wiring layer removal groove C is machined along the street St.

Subsequently, it is determined whether or not the machining points of the edge cutting laser beams L1a and L1b have reached the end point (machining end position) of the street St (step S7).

When the machining point reaches the end point of the street St, the edge cutting high-speed shutter 112A is closed (step S8). Thereby, the edge cutting process ends.

Subsequently, the hollowing high-speed shutter 112B is closed (step S9). Thereby, the hollowing process ends.

Subsequently, the machining feed operation is stopped (step S10). That is, the driving of the X-axis stage 31X is stopped and the machining feed operation of the table 10 is stopped.

The above steps complete the machining of one street St. Then, it is determined whether or not there is the next street St to be machined (step S11).

When there is the next street St to be machined, the next street St is machined. In this case, first, an index feed operation is applied to the table 10 toward the position of the next street St to be machined (step S12). The table 10 is subjected to the index feed operation based on an amount of feed corresponding to the spacing between the streets St (the spacing between the chips). Subsequently, the optical path of the hollowing laser beam L2 is switched (step S13). For example, when the machining feed direction is switched from the forward path to the return path, the optical path is switched so that the hollowing laser beam L2 is emitted from the second hollowing emission port 102B. On the other hand, in the case of switching from the return path to the forward path, the optical path is switched so that the hollowing laser beam L2 is emitted from the first hollowing emission port 102A. Subsequently, the above-described process of steps S4 to S10 is performed and the wiring layer removal groove C is machined in the street St.

On the other hand, when there is no next street St to be machined, i.e., when the machining of all streets St is completed, the edge cutting safety shutter 110A and the hollowing safety shutter 110B are closed (step S14). Thereby, the incidence of the laser beams LA and LB on the laser machining head 100 is blocked.

Subsequently, the wafer W is collected from the table 10 and the machining process for the wafer W is completed.

In this way, according to the workpiece machining apparatus 1 of the present embodiment, the edge cutting process and the hollowing process can be performed simultaneously in one machining feed operation (one path). Moreover, the same machining can be performed along both the forward and return paths.

### [Correction of tilt of condenser lens array]

### [Necessity of correction]

As described above, in the workpiece machining apparatus 1 of the present embodiment, a machining feed operation and an index feed operation are applied to the table 10 with respect to the laser machining head 100 and the wafer W on the table 10 is machined. The machining feed operation is applied to the table 10 when the X-axis stage 31X moves on the Y-axis stage 31Y. Moreover, the index feed operation is applied to the table 10 when the Y-axis stage 31Y moves on the base 2.

Here, if there is an undulation in the X direction on the movement axis of the Y-axis stage 31Y, in other words, if the straightness in the X direction is not 0, yawing occurs in the movement of the Y-axis stage 31Y. If yawing occurs in the movement of the Y-axis stage 31Y, the street St (the planned machining line) of the wafer W held on the table 10 is tilted with respect to the X-axis. Moreover, at the same time, the movement axis of the X-axis stage 31X is tilted and the machining feed direction is tilted.

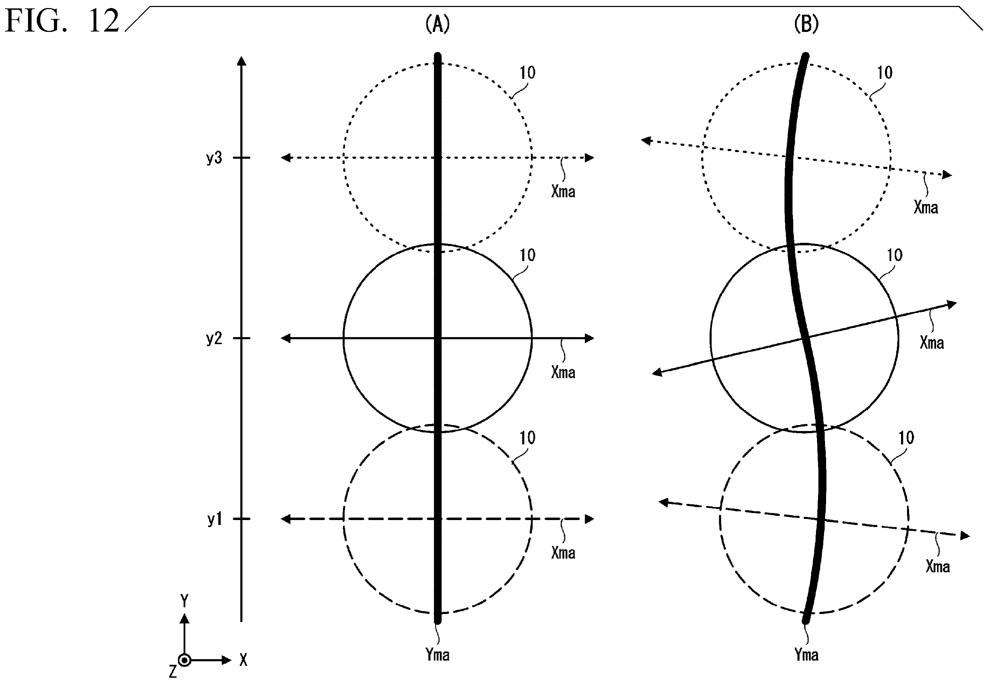

FIG. 12 is a conceptual diagram of occurrence of a tilt in the machining feed direction of the table due to yawing of the Y-axis stage.

FIG. 12(A) shows an example in which there is no undulation in the X direction on a movement axis Yma of the Y-axis stage 31Y, in other words, in which the straightness in the X direction is zero. Moreover, FIG. 12(B) shows an example in which there is an undulation in the X direction on the movement axis Yma of the Y-axis stage 31Y, in other words, in which the straightness in the X direction is not zero. In addition, for ease of description, the undulation is exaggerated.

In FIG. 12, reference sign Yma denotes the movement axis of the Y-axis stage 31Y. Moreover, reference sign Xma denotes the movement axis of the X-axis stage 31X. A direction of the movement axis of the X-axis stage 31X is the same as a direction of the street St. Moreover, reference signs y1, y2, and y3 indicate positions of the Y-axis stage 31Y, in other words, positions of the table 10 in the Y direction.

As shown in FIG. 12(A), when there is no undulation in the X direction on the movement axis Yma of the Y-axis stage 31Y, no tilt occurs in the movement axis Xma of the X-axis stage 31X at any position in the Y direction. Therefore, no tilt occurs with respect to the X-axis of the street St. Also, no tilt occurs in the machining feed direction of the table 10.

On the other hand, in FIG. 12(B), when the movement axis Yma of the Y-axis stage 31Y undulates in the X direction, the movement axis Xma of the X-axis stage 31X tilts in accordance with the undulation. Moreover, the street St tilts. Moreover, the tilt occurs in the machining feed direction.

When the tilt occurs in the machining feed direction of the table 10, a misalignment occurs between a position where the edge cutting process is performed with the laser machining head 100 and a position where the hollowing process is performed. As a result, a defect in which it is not possible to accurately hollow out the area between the two edge cutting grooves C1a and C1b occurs.

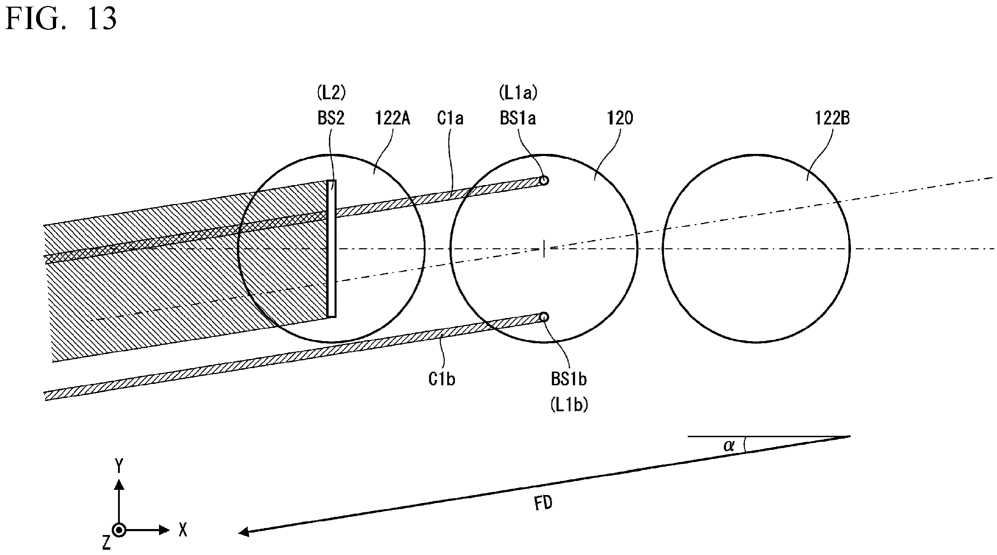

FIG. 13 is a conceptual diagram of a misalignment in machining position.

FIG. 13 shows an example of machining when the machining feed direction of the table 10 is tilted with respect to the X-axis. A direction of an arrow indicated by reference sign FD in FIG. 13 is the machining feed direction of the table 10 and is tilted by α° with respect to the X-axis in the XY plane.

As shown in FIG. 13, when the tilt occurs in the machining feed direction of the table 10, a misalignment occurs between the machining feed direction of the table 10 and the array direction of the edge cutting condenser lens 120, the first hollowing condenser lens 122A, and the second hollowing condenser lens 122B provided on the laser machining head 100. As a result, the edge cutting position and the hollowing position are misaligned and it is not possible to accurately hollow out the area between the two edge cutting grooves C1a and C1b.

### [Correction method]

When a misalignment with the condenser lens array direction occurs due to a tilt occurring in the machining feed direction of the table 10, the two are corrected so that they are parallel. In other words, the machining feed direction of the table 10 and the condenser lens array direction are corrected so that they coincide with each other. This correction is performed by correcting the positions of the first hollowing condenser lens 122A and the second hollowing condenser lens 122B using the first lens position adjustment unit 124A and the second lens position adjustment unit 124B.

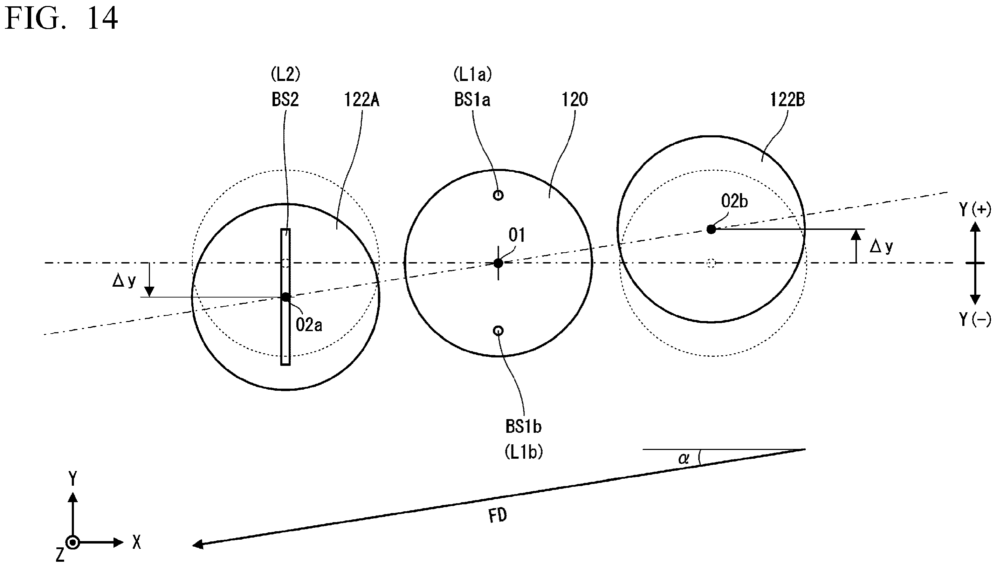

FIG. 14 is a conceptual diagram of correction.

In FIG. 14, a direction of an arrow indicated by reference sign FD is a machining feed direction of the table 10. The first hollowing condenser lens 122A and the second hollowing condenser lens 122B are moved in the Y direction so that the machining feed direction of the table coincides with the array direction of the edge cutting condenser lens 120, the first hollowing condenser lens 122A, and the second hollowing condenser lens 122B. In the example shown in FIG. 14, an example in which a correction process is performed by shifting the first hollowing condenser lens 122A by Δy in the Y (-) direction and shifting the second hollowing condenser lens 122B by Δy in the Y (+) direction is shown. The array direction of the three condenser lenses is defined as a direction of a straight line passing through optical axes O1, O2a, and O2b of the condenser lenses 120, 122A, and 122B.

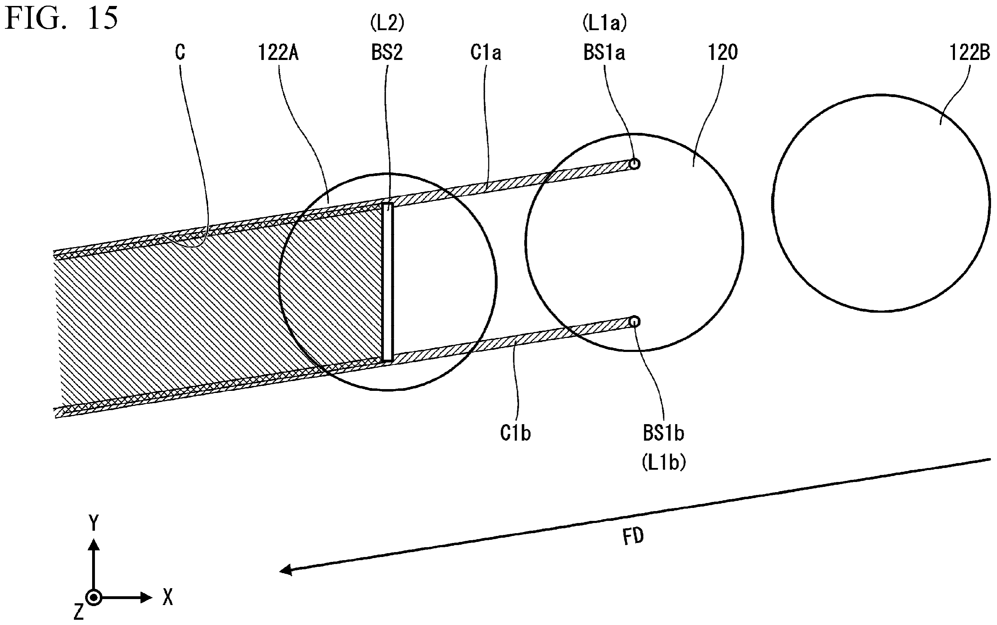

FIG. 15 is a diagram showing an example of a machining state after correction.

As shown in FIG. 15, a misalignment between a position of the edge cutting process and a position of the hollowing process is corrected by causing the machining feed direction of the table 10 to coincide with the array direction of the edge cutting condenser lens 120, the first hollowing condenser lens 122A, and the second hollowing condenser lens 122B. As a result, it is possible to accurately hollow out the area between the two edge cutting grooves C1a and C1b.

When the spacing between the two edge cutting grooves changes due to the correction of the array direction, the spacing between the beam spots BS1a and BS1b of the pair of edge cutting laser beams L1a and L1b is corrected as necessary. The spacing between the beam spots BS1a and BS1b is corrected by rotating the optical splitting element 114A to rotate the beam spots BS1a and BS1b around the optical axis of the edge cutting condenser lens 120.

Likewise, when a machining width of the hollowing process changes due to the correction of the array direction, the machining width is corrected as necessary. The machining width of the hollowing process is corrected by rotating the diffractive optical element 116A to rotate the hollowing laser beam L2 around the optical axis.

In addition, in the present embodiment, a process for causing the machining feed direction of the table 10 to coincide with the array direction of the condenser lenses is synonymous with a process for causing the direction of the street St of the wafer W on the table 10 to coincide with the array direction of the condenser lenses. In other words, it is synonymous with a process for correcting a relative tilt of the array direction of the condenser lenses for the street St.

### [Correction control]

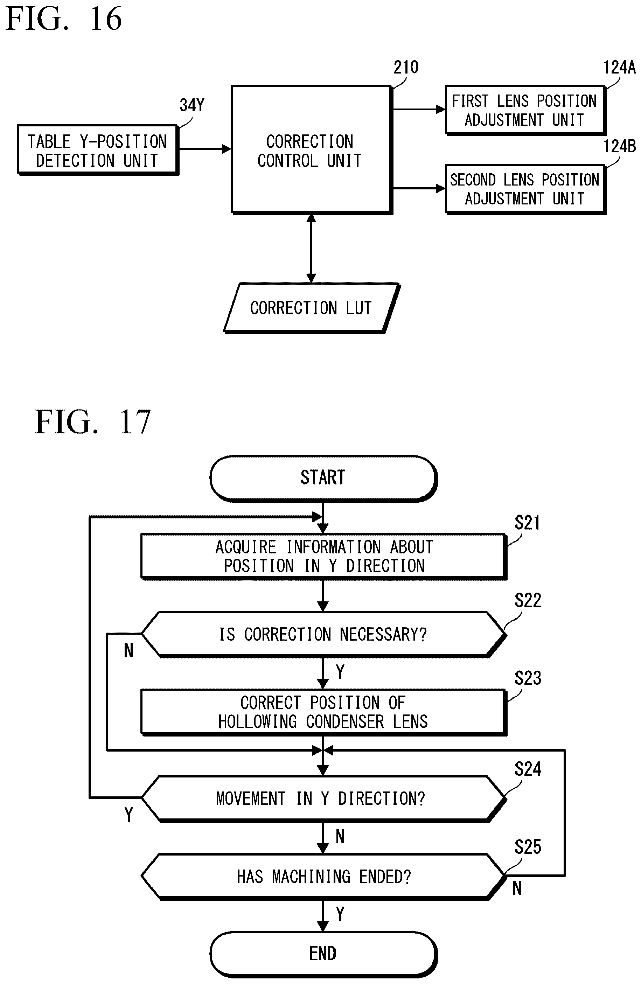

FIG. 16 is a block diagram of a function implemented by the control device in relation to correction of a tilt of an array of the condenser lenses.

In relation to the correction of the tilt of the array of the condenser lenses, the control device 200 functions as a correction control unit 210.

The correction control unit 210 controls the first lens position adjustment unit 124A and the second lens position adjustment unit 124B on the basis of the position of the table 10 in the Y direction and corrects positions of the first hollowing condenser lens 122A and the second hollowing condenser lens 122B.

As described above, when there is undulation in the X direction on the movement axis of the Y-axis stage 31Y, the machining feed direction of the table 10 changes with the position of the Y-axis stage 31Y, i.e., the position of the table 10 in the Y direction. In other words, the orientation changes due to yawing. For this reason, the correction control unit 210 corrects the positions of the first hollowing condenser lens 122A and the second hollowing condenser lens 122B in accordance with the position of the table 10 in the Y direction.

The position of the table 10 in the Y direction is a relative position for the laser machining head 100 in the Y direction. The position of the table 10 in the Y direction is detected by the table Y-position detection unit 34Y. Therefore, the correction control unit 210 controls the first lens position adjustment unit 124A and the second lens position adjustment unit 124B on the basis of an output of the table Y-position detection unit 34Y.

Here, the undulation of the Y-axis stage 31Y in the X direction can be measured in advance. Therefore, the tilt (yawing) in the machining feed direction that occurs for each position in the Y direction can also be measured in advance. Therefore, information about an amount of correction required for each position in the Y direction can also be acquired in advance. Information about the amount of correction required for each position in the Y direction is information about amounts of movement of the first hollowing condenser lens 122A and the second hollowing condenser lens 122B required to correct the tilt misalignment. Information about the amount of correction for each position of the table 10 in the Y direction is stored as a correction lookup table (LUT) in the auxiliary storage device 200C of the control device 200. The correction control unit 210 controls the first lens position adjustment unit 124A and the second lens position adjustment unit 124B with reference to the correction lookup table, and corrects the positions of the first hollowing condenser lens 122A and the second hollowing condenser lens 122B.

In the present embodiment, the correction control unit 210 is an example of a correction unit. Moreover, the first lens position adjustment unit 124A and the second lens position adjustment unit 124B are examples of a correction unit. Moreover, information about the amount of correction for each position in the Y direction is an example of correction information, and the auxiliary storage device 200C that stores this information is an example of a storage unit.

### [Correction process]

FIG. 17 is a flowchart showing a flow of a correction process for the tilt of the condenser lens array.

First, the correction control unit 210 acquires information about a current position of the table 10 in the Y direction (step S21). The position of the table 10 in the Y direction is detected by the table Y position detection unit 34Y. The correction control unit 210 acquires information about the current position of the table 10 in the Y direction from the table Y position detection unit 34Y.

Subsequently, the correction control unit 210 determines whether or not correction is necessary on the basis of the current position of the table 10 in the Y direction (step S22). The correction control unit 210 determines whether or not correction is necessary with reference to the correction lookup table. If the amount of correction for the current position of the table 10 is 0, the correction control unit 210 determines that the correction is unnecessary.

When the correction is necessary, the correction control unit 210 corrects the positions of the first hollowing condenser lens 122A and the second hollowing condenser lens 122B on the basis of information recorded in the correction lookup table (step S23). That is, the first hollowing condenser lens 122A and the second hollowing condenser lens 122B are moved in the Y direction according to the information recorded in the correction lookup table to correct the array direction of the edge cutting condenser lens 120, the first hollowing condenser lens 122A, and the second hollowing condenser lens 122B. According to this correction, the machining feed direction of the table 10 coincides with the array direction of the three condenser lenses. That is, the machining feed direction of the table 10 and the array direction of the three condenser lenses become parallel. Moreover, this correction causes the direction of the street St of the wafer W on the table 10 to coincide with the array direction of the three condenser lenses. That is, the three condenser lenses are arranged along the street St. Thereby, the edge cutting process and the hollowing process can be executed along the street St without any misalignment.

Subsequently, the correction control unit 210 determines whether or not the table 10 has moved in the Y direction (step S24). That is, it is determined whether or not the index feed operation has been applied to the table 10.

If it is determined that the table 10 has moved in the Y direction, the correction control unit 210 executes the above-described process of steps S21 to S23 and performs a tilt correction process as necessary.

When it is determined that the table 10 has not moved, the correction control unit 210 determines whether or not machining has ended (step S25). When the machining ends, the correction process also ends.

As described above, according to the workpiece machining apparatus 1 of the present embodiment, even if the position of the table 10 in the Y direction causes a tilt in the machining feed direction, the edge cutting process and the hollowing process can be performed along the street St without any misalignment. Therefore, the wafer W can be machined with high precision.

### [Modified examples]

### [Modified example of correction unit]

Although the configuration in which the first hollowing condenser lens 122A and the second hollowing condenser lens 122B are moved in the Y direction to correct the tilt in the array direction of the edge cutting condenser lens 120, the first hollowing condenser lens 122A, and the second hollowing condenser lens 122B has been adopted in the above embodiment, a configuration in which the tilt in the array direction of the three condenser lenses is corrected is not limited thereto.

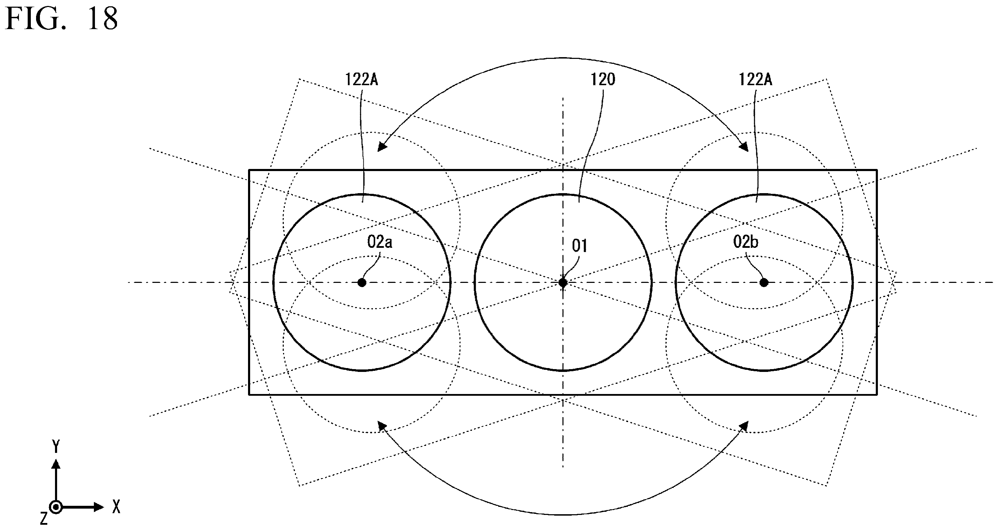

FIG. 18 is a conceptual diagram showing another example of a configuration in which the tilt of the array direction of the condenser lenses is corrected.

The configuration shown in FIG. 18 rotates three condenser lenses together around an axis parallel to the Z axis to correct the tilt of the array direction. FIG. 18 shows an example of a configuration in which three condenser lenses are rotated together around the optical axis O1 of the edge cutting condenser lens 120. With this configuration, it is possible to change the array direction of the three condenser lenses in accordance with a change in the machining feed direction of the table 10.

This configuration can be implemented, for example, by holding the laser machining head 100 rotatably around the optical axis of the edge cutting condenser lens 120.

### [Feed drive unit]

Although a configuration in which the table 10 is moved in the X and Y directions and the feed operation is applied in the X and Y directions has been adopted in the above-described embodiment, a configuration in which the laser machining head 100 is moved in the X and Y directions and the feed operation is applied in the X and Y directions may be adopted. In this case, a configuration in which the table 10 is moved in the Z direction may be adopted.

### [Others]

Due to distortion over time or thermal distortion or the like, a misalignment may occur in a positional relationship between the edge cutting condenser lens 120 and the first hollowing condenser lens 122A or the second hollowing condenser lens 122B and a misalignment may occur in the machining position between the edge cutting process and the hollowing process. In such a case, the first lens position adjustment unit 124A and the second lens position adjustment unit 124B can be used to adjust the positions of the first hollowing condenser lens 122A and the second hollowing condenser lens 122B, thereby correcting the misalignment in the positional relationship and therefore the misalignment in the machining position. Thereby, more accurate machining can be implemented.

Although a configuration in which the information about the amount of correction (correction information) is held in the form of a lookup table has been adopted in the above embodiment, a form in which the information about the amount of correction is held is not limited thereto. It is only necessary to hold a position (coordinate) in the Y direction and information about an amount of correction at the position.

### [Second embodiment]

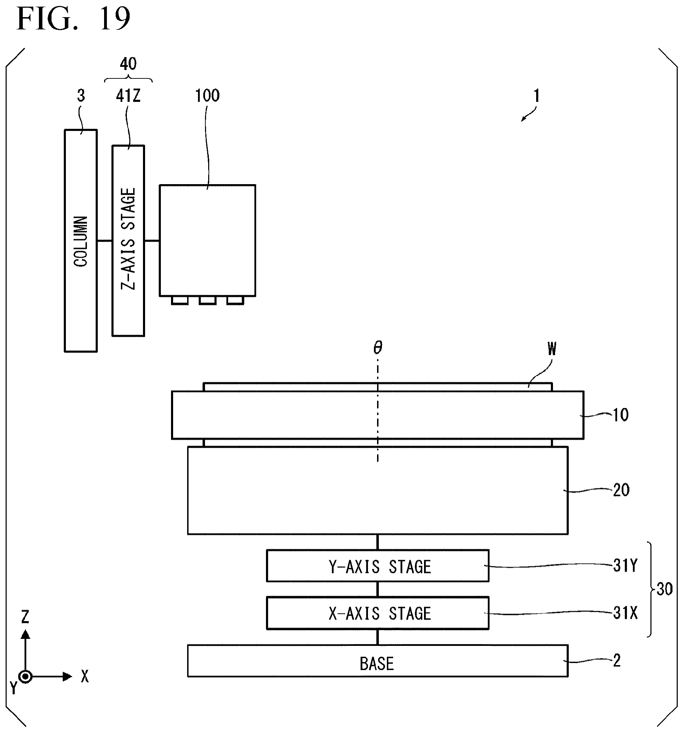

FIG. 19 is a diagram showing a schematic configuration of a workpiece machining apparatus in a second embodiment.

A workpiece machining apparatus 1 of the present embodiment is different from the workpiece machining apparatus 1 of the above-described first embodiment in a configuration of a table feed drive unit 30. In the workpiece machining apparatus 1 of the above-described first embodiment, an X-axis stage 31X is provided on a Y-axis stage 31Y. In the workpiece machining apparatus 1 of the present embodiment, the Y-axis stage 31Y is provided on the X-axis stage 31X.

As shown in FIG. 19, in the workpiece machining apparatus 1 of the present embodiment, the X-axis stage 31X is provided on a base 2. The X-axis stage 31X moves in an X direction on the base 2. The Y-axis stage 31Y is provided on the X-axis stage 31X and moves in a Y direction on the X-axis stage 31X. A table 10 is mounted on the Y-axis stage 31Y.

The other configuration is basically the same as that of the workpiece machining apparatus 1 of the first embodiment described above. However, a first lens position adjustment unit 124A and a second lens position adjustment unit 124B are not necessarily required. The first lens position adjustment unit 124A and the second lens position adjustment unit 124B are provided so that they can be used for a process for correcting a machining position misalignment or the like.

### [Problems]

If there is undulation in the X direction on the movement axis of the Y-axis stage 31Y, yawing occurs due to the movement of the table 10 in the Y direction and the street St of the wafer W held on the table 10 is tilted, as in the workpiece machining apparatus 1 of the first embodiment.

In the workpiece machining apparatus 1 of the present embodiment, parallelism between the array direction of the condenser lenses and the machining feed direction of the table 10 is ensured. Therefore, in principle, there is no positional misalignment between the edge cutting process and the hollowing process.

However, because the street St is tilted, if machining is continued as it is, the wiring layer removal groove C will be machined in a misalignment with the street St.

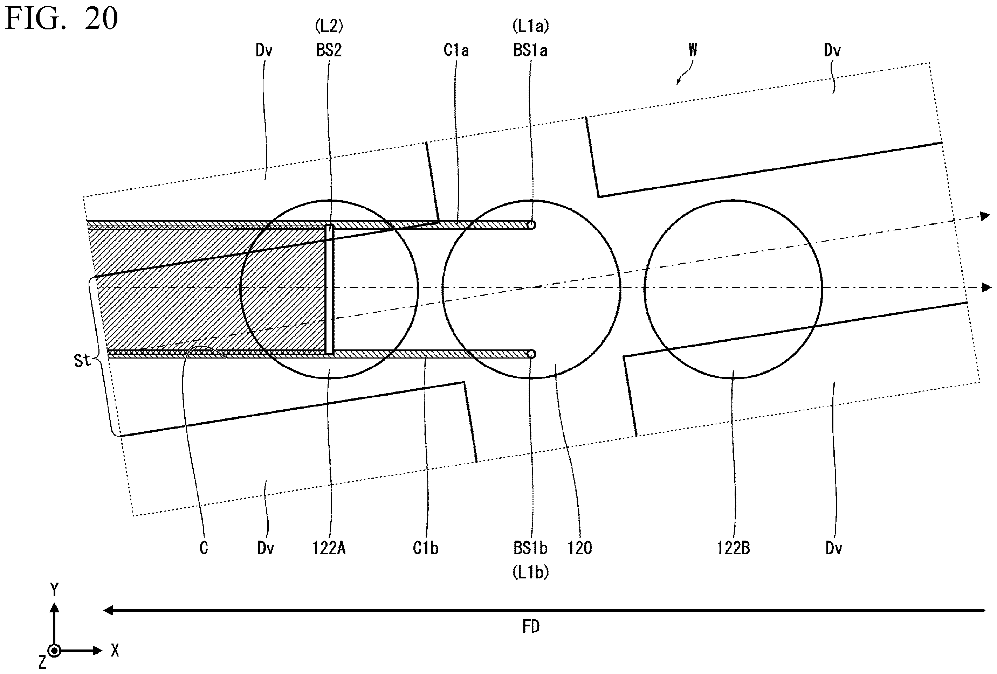

FIG. 20 shows an example of machining when the street is tilted.

In FIG. 20, a direction of an arrow indicated by reference sign FD is a machining feed direction of the table 10. As shown in FIG. 20, a machining feed direction of the table coincides with an array direction of an edge cutting condenser lens 120, a first hollowing condenser lens 122A, and a second hollowing condenser lens 122B. Therefore, two edge cutting grooves C1a and C1b are machined in the machining feed direction, and a hollowing process is also performed between the two edge cutting grooves C1a and C1b in the machining feed direction. Therefore, a wiring layer removal groove C itself is machined accurately. However, because the street St on the table is tilted with respect to the X-axis, it is machined in a misalignment with the street St. In other words, the wiring layer removal groove C is machined at an angle with respect to the street St.

### [Correction method]

The table 10 is rotated so that the street St and the array direction of the condenser lens are parallel to each other, and a relative tilt therebetween is corrected.

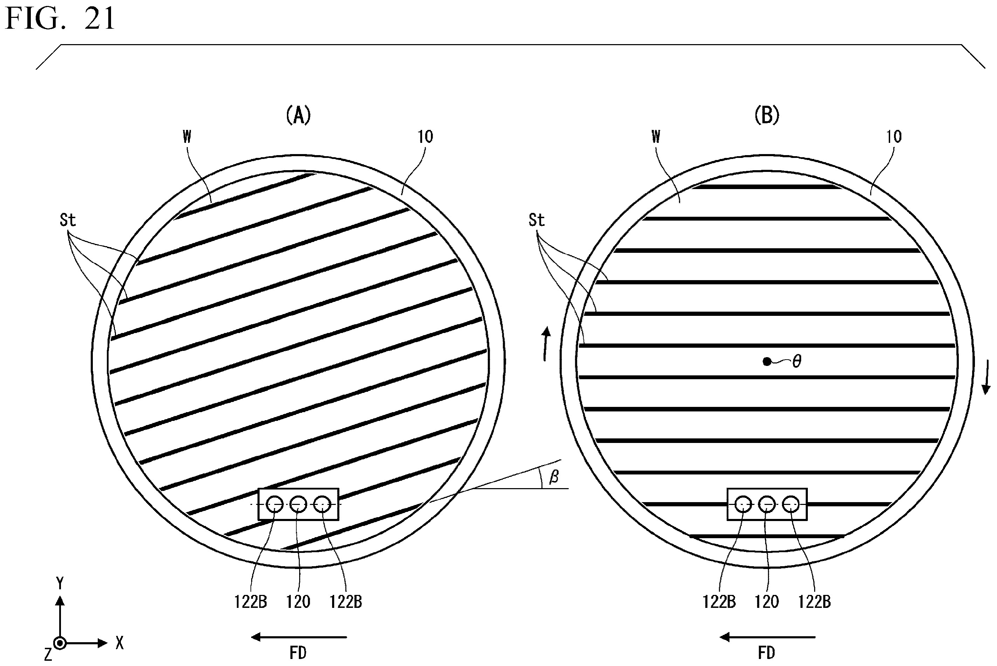

FIG. 21 is a conceptual diagram of correction. In FIG. 21, (A) shows a state before the correction and (B) shows a state after the correction.

As shown in FIG. 21(A), in the state before the correction, the street St of the wafer W on the table 10 is tilted by β° with respect to the array direction (the X direction) of the edge cutting condenser lens 120, the first hollowing condenser lens 122A, and the second hollowing condenser lens 122B.

In this case, as shown in FIG. 21(B), the table 10 is rotated by β° around the θ axis to correct the tilt of the street St. More specifically, the tilt is corrected by rotating by β° in a direction opposite to the tilted direction.

Thereby, the direction of the street St coincides with the array direction of the three condenser lenses. In other words, the three condenser lenses are arranged along the street St. According to a machining process in this state, the wiring layer removal groove C can be machined along the street St.

### [Correction control]

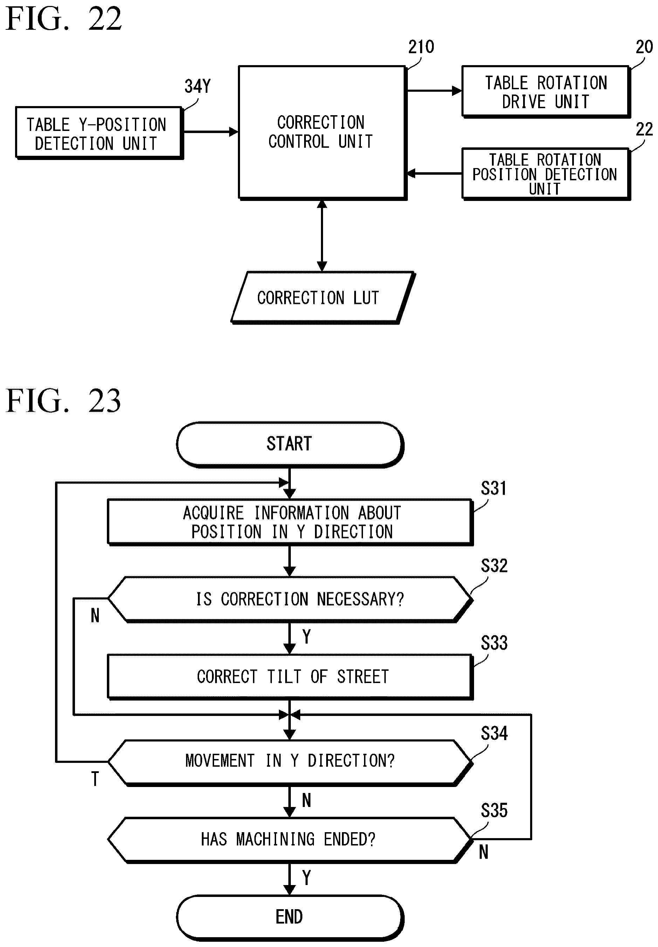

FIG. 22 is a block diagram of functions implemented by the control device in relation to the correction of the tilt of the condenser lens array.

The correction control unit 210 controls the table rotation drive unit 20 on the basis of the position of the table 10 in the Y direction and corrects the tilt of the street St.

As described above, because the undulation of the Y-axis stage 31Y in the X direction can be measured in advance, the tilt of the street St occurring at each position in the Y direction can also be measured in advance. Therefore, information about the amount of correction required for each position in the Y direction, in other words, information about the amount of rotation of the table 10 required to correct the tilt, can also be acquired in advance. Information about the amount of correction for each position in the Y direction of the table 10 is stored as a correction lookup table in the auxiliary storage device 200C of the control device 200. The correction control unit 210 controls the table rotation drive unit 20 with reference to the correction lookup table and corrects the tilt of the street St.

In the present embodiment, the correction control unit 210 is an example of a correction unit. Moreover, the table rotation drive unit 20 is an example of a correction unit. Also, information about the amount of correction for each position in the Y direction is an example of correction information, and the auxiliary storage device 200C storing the information is an example of a storage unit.

### [Correction process]

FIG. 23 is a flowchart showing a flow of a process for correcting the tilt of the array of condenser lenses.

First, the correction control unit 210 acquires information about a current position of the table 10 in the Y direction (step S31). The position of the table 10 in the Y direction is detected by the table Y-position detection unit 34Y. The correction control unit 210 acquires information about the current position of the table 10 in the Y direction from the table Y-position detection unit 34Y.

Subsequently, the correction control unit 210 determines whether or not correction is necessary on the basis of the current position of the table 10 in the Y direction (step S32). The correction control unit 210 determines whether or not correction is necessary with reference to the correction lookup table. If an amount of correction for the current position of the table 10 is 0, the correction control unit 210 determines that correction is unnecessary.

If the correction is necessary, the correction control unit 210 corrects the tilt of the street St on the basis of the information recorded in the correction lookup table (step S33). That is, the table 10 is rotated in accordance with the information recorded in the correction lookup table to correct the tilt of the street St. According to this correction, the direction of the street St coincides with the array direction of the three condenser lenses. In other words, the direction of the street St is parallel to the array direction of the edge cutting condenser lens 120, the first hollowing condenser lens 122A, and the second hollowing condenser lens 122B. That is, the above-described three condenser lenses are arranged along the street St. Thereby, it is possible to machine the wiring layer removal groove C along the street St.

Subsequently, the correction control unit 210 determines whether or not the table 10 has moved in the Y direction (step S34). That is, it is determined whether or not an index feed operation has been applied to the table 10.

If it is determined that the table 10 has moved in the Y direction, the correction control unit 210 executes the above-described process of steps S21 to S23 and performs a process for correcting the tilt of the street St as necessary.

When it is determined that the table 10 has not moved, the correction control unit 210 determines whether or not the machining has ended (step S35). When the machining ends, the correction process also ends.

As described above, according to the workpiece machining apparatus 1 of the present embodiment, even if the street St is tilted due to the position of the table 10 in the Y direction, the edge cutting process and the hollowing process can be performed along the street St without any misalignment. Therefore, the wafer W can be machined with high precision.

In addition, the modified examples of the above embodiment can also be applied to the workpiece machining apparatus 1 of the present embodiment as appropriate. Therefore, for example, a configuration in which the laser machining head 100 may be moved in the X direction and the Y direction to apply a feed operation in the X direction and the Y direction may be adopted.

### [Third embodiment]

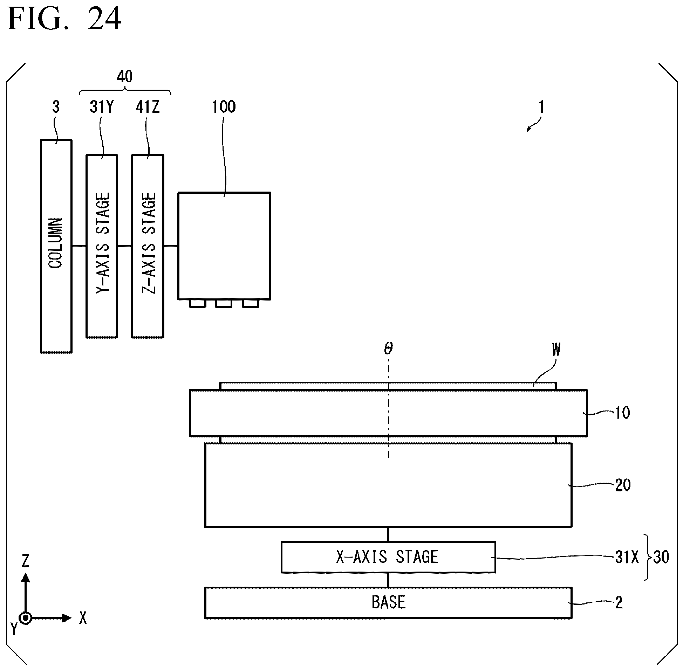

FIG. 24 is a diagram showing a schematic configuration of a workpiece machining apparatus.

In a workpiece machining apparatus 1 of the present embodiment, a table 10 moves only in an X direction, and a laser machining head 100 moves in Y and Z directions. That is, a feed operation in the Y direction is applied by the movement of the laser machining head 100.

As shown in FIG. 24, the table 10 is mounted on an X-axis stage 31 that moves in the X direction on a base 2. The table 10 is fed in the machining direction by the movement of the X-axis stage 31 in the X direction.

The laser machining head 100 is mounted on a Z-axis stage 41Z that moves in the Z direction on a column 3. For the column 3, the Z-axis stage 41Z moves on a Y-axis stage 31Y in the Z direction. The Y-axis stage 31Y moves on the column 3 in the Y direction.

The other configuration is basically the same as that of the workpiece machining apparatus 1 of the first embodiment described above. Therefore, a first lens position adjustment unit 124A and a second lens position adjustment unit 124B are provided.

### [Problems]

In the case of the workpiece machining apparatus 1 of the present embodiment, if there is an undulation in the X direction on a movement axis of the Y-axis stage 31Y, the movement of the Y-axis stage 31Y causes the laser machining head 100 to tilt. As a result, a tilt occurs in an array direction of an edge cutting condenser lens 120, a first hollowing condenser lens 122A, and a second hollowing condenser lens 122B with respect to a machining feed direction of the wafer W. For this reason, if machining is performed as it is, a situation in which the hollowing process cannot be performed accurately will occur.

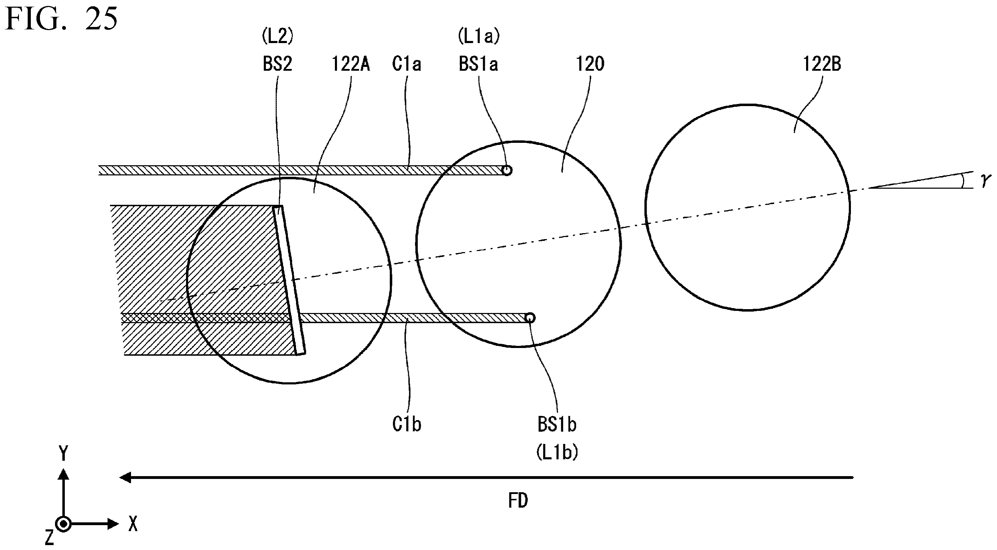

FIG. 25 is a diagram showing an example of machining when a tilt occurs in the array direction of the condenser lenses.

In FIG. 25, a direction of an arrow indicated by reference sign FD is the machining feed direction of the table 10. The edge cutting condenser lens 120, the first hollowing condenser lens 122A, and the second hollowing condenser lens 122B are arranged at a tilt of γ° in an XY plane with respect to the machining feed direction of the table 10.

As shown in FIG. 25, if the array direction of the three condenser lenses is tilted with respect to the machining feed direction, the position of each condenser lens in the Y direction is misaligned. As a result, the edge cutting position and the hollowing position will be misaligned, and it is not possible to accurately hollow out an area between the two edge cutting grooves C1a and C1b.

### [Correction method]

As in the workpiece machining apparatus 1 of the first embodiment described above, the first hollowing condenser lens 122A and the second hollowing condenser lens 122B are moved in the Y direction to align the array direction of the condenser lenses with the machining feed direction of the wafer W (the direction of the street St to be machined).

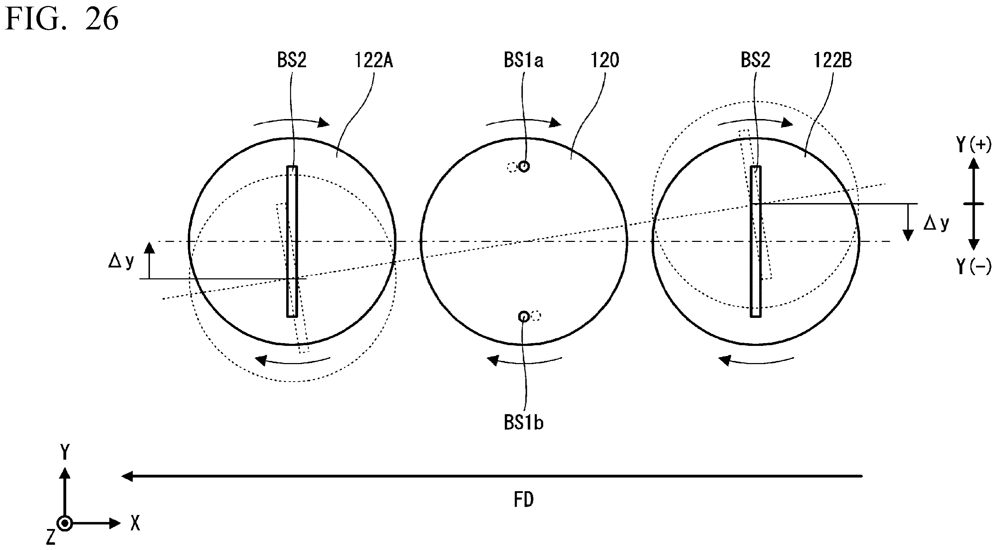

FIG. 26 is a conceptual diagram of correction.

In FIG. 26, a direction of an arrow indicated by reference sign FD is a machining feed direction of the table 10. The first hollowing condenser lens 122A and the second hollowing condenser lens 122B are moved in the Y direction so that the machining feed direction of the table coincides with the array direction of the edge cutting condenser lens 120, the first hollowing condenser lens 122A, and the second hollowing condenser lens 122B.

Moreover, when the beam spot of the laser beam emitted from each condenser lens is tilted due to the tilt of the array direction, the beam spot is rotated around the optical axis as necessary to correct the tilt.

In the example shown in FIG. 26, an example in which a correction process is performed by shifting the first hollowing condenser lens 122A by Δy in the Y (+) direction and shifting the second hollowing condenser lens 122B by Δy in the Y (-) direction is shown. Moreover, the example in which the tilt is corrected by rotating the beam spot of each laser beam is shown.

### [Correction control]

In relation to the correction of the tilt of the condenser lens array, the control device 200 functions as a correction control unit 210 (see FIG. 16). As in the workpiece machining apparatus 1 of the first embodiment, the correction control unit 210 controls the first lens position adjustment unit 124A and the second lens position adjustment unit 124B on the basis of the position of the table 10 in the Y direction and corrects the positions of the first hollowing condenser lens 122A and the second hollowing condenser lens 122B. The correction control unit 210 controls the first lens position adjustment unit 124A and the second lens position adjustment unit 124B with reference to the correction lookup table stored in an auxiliary storage device 200C. Information about an amount of correction (correction information) for each position in the Y direction of the table 10 is recorded in the correction lookup table.

In the present embodiment, the correction control unit 210 is an example of a correction unit. Moreover, the first lens position adjustment unit 124A and the second lens position adjustment unit 124B are examples of a correction unit. The information about the amount of correction for each position in the Y direction is also an example of correction information and the auxiliary storage device 200C that stores this information is an example of a storage unit.

### [Correction process]

The flow of the correction process is basically the same as that of the workpiece machining apparatus 1 of the first embodiment. Hereinafter, a process for correcting the tilt of the array of the condenser lenses in the workpiece machining apparatus 1 of the present embodiment will be described with reference to FIG. 17.

First, the correction control unit 210 acquires information about a current position of the table 10 in the Y direction (step S21).

Subsequently, the correction control unit 210 determines whether or not correction is necessary on the basis of the current position of the table 10 in the Y direction (step S22). The correction control unit 210 determines whether or not correction is necessary with reference to a correction lookup table. If an amount of correction for the current position of the table 10 is 0, the correction control unit 210 determines that the correction is not necessary.

When the correction is necessary, the correction control unit 210 corrects the positions of the first hollowing condenser lens 122A and the second hollowing condenser lens 122B on the basis of information recorded in the correction lookup table (step S23). That is, the first hollowing condenser lens 122A and the second hollowing condenser lens 122B are moved in the Y direction according to the information recorded in the correction lookup table to correct the array direction of the edge cutting condenser lens 120, the first hollowing condenser lens 122A, and the second hollowing condenser lens 122B. According to this correction, the machining feed direction of the table 10 coincides with the array direction of the three condenser lenses. That is, the machining feed direction of the table 10 becomes parallel to the array direction of the edge cutting condenser lens 120, the first hollowing condenser lens 122A, and the second hollowing condenser lens 122B. Moreover, according to this correction, the direction of the street St of the wafer W on the table 10 coincides with the array direction of the three condenser lenses. That is, the three condenser lenses are arranged along the street St. Thereby, the edge cutting process and the hollowing process can be executed along the street St without any misalignment. Moreover, the tilt of the beam spot is corrected as necessary. Thereby, the interval between the two edge cutting grooves C1a and C1b to be machined is corrected, and the machining width of the hollowing process is corrected. Moreover, thereby, the wiring layer removal groove C can be machined with the correct machining width.

Subsequently, the correction control unit 210 determines whether or not the table 10 has moved in the Y direction (step S24). That is, it is determined whether or not an index feed operation has been applied to the table 10.

If it is determined that the table 10 has moved in the Y direction, the correction control unit 210 executes the above-described process of steps S21 to S23 and performs the tilt correction process as necessary.

When it is determined that the table 10 has not moved, the correction control unit 210 determines whether or not the machining has ended (step S25). When the machining ends, the correction process also ends.

As described above, according to the workpiece machining apparatus 1 of the present embodiment, even if a tilt occurs in the array direction of the condenser lenses according to the position of the table 10 in the Y direction, the edge cutting process and the hollowing process can be executed along the street St without any misalignment. Therefore, the wafer W can be machined with high precision.

### [Modified example]

### [Modified example of correction unit]

As in the workpiece machining apparatus 1 of the first embodiment, a configuration in which three condenser lenses are rotated together around an axis parallel to a Z axis, for example, around the optical axis of an edge cutting condenser lens 120, to correct a tilt in an array direction (see FIG. 18) can be adopted.

### [Others]

Although a Z-axis stage 41Z is configured to move in a Z direction on a Y-axis stage 31Y in the above-described embodiment, the Y-axis stage 31Y may also be configured to move in a Y direction on the Z-axis stage 41Z.

Although the Y-axis stage 31Y is configured to move in the Y direction on a column 3 in the above-described embodiment, a configuration in which the Y-axis stage 31Y moves in the Y direction on a base 2 and a column 3 is provided on the Y-axis stage 31Y may be adopted.

In addition, the modified examples of the first and second embodiments can be applied to the workpiece machining apparatus 1 of the present embodiment as appropriate.

### [Other embodiments]

### [Laser machining head]

Although two hollowing machining units (condenser lenses) are configured on one laser machining head in the above-described embodiment, it is only necessary to provide at least one hollowing machining unit. That is, the minimum configuration is a configuration in which one edge cutting machining unit and one hollowing machining unit are provided. In this configuration, in the case of machining along a single path, the number of machining directions is limited to one. Moreover, it is possible to further provide a plurality of hollowing machining units. By providing a plurality of hollowing machining units on one side of the edge cutting machining unit, it is possible to divide a hollowing process into a plurality of steps along a single path to execute the plurality of steps.

In addition, as a method of executing the hollowing process a plurality of times along a single path, a configuration in which multiple hollowing laser beams are emitted from one machining unit (condenser lens) can be adopted. In this case, for example, a configuration in which the hollowing laser beam is split into a plurality of beams using an optical splitting element such as a diffractive optical element, a refractive optical element, or a Wollaston prism and the laser beams are output from one machining unit can be adopted.

### [Laser machining unit]

Although a configuration in which the machining unit for performing the edge cutting process and the machining unit for performing the hollowing process are integrated (or mounted on one laser machining head 100) have been described in the above-described embodiment, the machining unit for performing the edge cutting process and the machining unit for performing the hollowing process may be configured as separate independent units. For example, in the workpiece machining apparatus 1 of the first embodiment described above, the machining unit for performing the edge cutting process and the machining unit for performing the hollowing process may be separated and configured to move separately in the Z direction.

### [Shape of beam spot]

Although the shape of the beam spot of the hollowing laser beam is rectangular in the above-described embodiment, the shape of the beam spot of the hollowing laser beam is not limited thereto. For example, in the case where the machining width is not adjusted and the like, the shape of the beam spot may be circular. In addition, when the machining width is adjusted by rotation around the optical axis, it is only necessary for the beam spot to be non-circular. In other words, it is only necessary for the shape to have a width varying in a direction perpendicular to the machining feed direction in the case of rotation around the optical axis. Therefore, for example, the shape can be linear, elliptical, or the like.

### [Others]

Although an example in which a device for removing a wiring layer including a low-k film from the street before dicing a semiconductor wafer using a low-k film as an interlayer insulating film has been described in the above-described embodiment, the application of the present invention is not limited thereto. For example, the present invention can also be applied to a device for machining two grooves along a street with laser beams and cutting an area between the two grooves with a laser beam.

### REFERENCE SIGNS LIST

1 Workpiece machining apparatus
2 Base
3 Column
10 Table
20 Table rotation drive unit
22 Table rotation position detection unit
22A Edge cutting laser beam source
22B Hollowing laser beam source
30 Table feed drive unit
31X X-axis stage
31Y Y-axis stage
32X X-axis guide unit
32Xa Guide rail
32Xb Slider
32Y Y-axis guide unit
32Ya Guide rail
32Yb Slider
33X X-axis drive mechanism
33Xa Screw shaft
33Xb Bearing
33Xc Nut
33Xd X-axis motor
33Y Y-axis drive mechanism
33Ya Screw shaft
33Yb Bearing
33Yc Nut
33Yd Y-axis motor
34X Table X-position detection unit
34Y Table Y-position detection unit
40 Head feed drive unit
41Z Z-axis stage
42Z Z-axis guide unit
42Za Guide rail
42Zb Slider
43Z Z-axis drive mechanism
43Za Screw shaft
43Zb Bearing
43Zc Nut
43Zd Z-axis motor
44 Head position detection unit
50 Microscope
100 Laser machining head
101 Edge cutting emission port
102A Hollowing emission port (first hollowing emission port)
102B Hollowing emission port (second hollowing emission port)
110A Edge cutting safety shutter
110B Hollowing safety shutter
112A Edge cutting high-speed shutter
112B Hollowing high-speed shutter
114 Edge cutting laser beam generation unit
114A Optical splitting element
114B Optical splitting element rotation drive unit
116 Hollowing laser beam generation unit
116A Diffractive optical element
116B Diffractive optical element rotation drive unit
118 Hollowing optical path switching unit
118A 1/2 wavelength plate (1/2λ plate)
118B Wavelength plate rotation drive unit
118C Polarizing beam splitter
120 Edge cutting condenser lens
122A First hollowing condenser lens
122B Second hollowing condenser lens
124A First lens position adjustment unit
124B Second lens position adjustment unit
200 Control device
200A Processor
200B Main storage device
200C Auxiliary storage device
200D Input device
200E Output device
BS1a Beam spot
BS2 Beam spot
C Groove (wiring layer removal groove)
C1a Groove (edge cutting groove)
C1b Groove (edge cutting groove)
Dv Device
L1a Laser beam (edge cutting laser beam)
L1b Laser beam (edge cutting laser beam)
L2 Laser beam (hollowing laser beam)
LA Laser beam (laser beam emitted from edge cutting laser beam source)
LB Laser beam (laser beam emitted from hollowing laser beam source)
St Street
W Wafer

## Claims

1. A workpiece machining apparatus comprising:
a table configured to hold a workpiece;
a machining unit having a first machining unit and a second machining unit arrayed in an X direction and configured to machine two grooves along a planned machining line by radiating a pair of first laser beams from the first machining unit with respect to the table relatively fed in the X direction along the planned machining line set in a workpiece and machine an area between the two grooves by radiating a second laser beam from the second machining unit between the two grooves machined by the first machining unit;
a feed drive unit configured to apply a feed operation in the X direction and a Y direction orthogonal to the X direction by relatively moving the table and the machining unit in the X direction and the Y direction;
a correction unit configured to correct a tilt of an array of the first machining unit and the second machining unit for the planned machining line; and
a control unit configured to control a tilt correction process of the correction unit.

2. The workpiece machining apparatus according to claim 1,
wherein the correction unit corrects the tilt occurring in the feed operation of the feed drive unit in the Y direction, and
wherein the control unit controls the tilt correction process of the correction unit on the basis of a relative position in the Y direction between the table and the machining unit.

3. The workpiece machining apparatus according to claim 2, further comprising a storage unit storing tilt correction information according to the relative position,
wherein the control unit controls the tilt correction process of the correction unit with reference to the correction information.

4. The workpiece machining apparatus according to claim 3,
wherein the machining unit has a plurality of second machining units, and
wherein the second machining units are arranged in front of and behind the first machining unit in the X direction in a state in which the first machining unit is sandwiched therebetween.

5. The workpiece machining apparatus according to any one of claims 1 to 4,
wherein the feed drive unit includes a Y-axis stage moving in the Y direction and an X-axis stage moving in the X direction on the Y-axis stage,
wherein the table is mounted on the X-axis stage, and
wherein the correction unit corrects the tilt by relatively moving the first machining unit and the second machining unit in the Y direction.

6. The workpiece machining apparatus according to any one of claims 1 to 4,
wherein the feed drive unit includes a Y-axis stage moving in the Y direction and an X-axis stage moving in the X direction on the Y-axis stage,
wherein the table is mounted on the X-axis stage, and
wherein the correction unit corrects the tilt by integrally rotating the first machining unit and the second machining unit around an axis orthogonal to an XY plane.

7. The workpiece machining apparatus according to any one of claims 1 to 4,
wherein the feed drive unit includes an X-axis stage moving in the X direction and a Y-axis stage moving in the Y direction on the X-axis stage,
wherein the table is mounted on the Y-axis stage, and
wherein the correction unit corrects the tilt by rotating the table around an axis.

8. The workpiece machining apparatus according to any one of claims 1 to 4,
wherein the feed drive unit includes an X-axis stage independently moving in the X direction and a Y-axis stage independently moving in the Y direction,
wherein the table is mounted on the X-axis stage,
wherein the machining unit is mounted on the Y-axis stage, and
wherein the correction unit corrects the tilt by relatively moving the first machining unit and the second machining unit in the Y direction.

9. The workpiece machining apparatus according to any one of claims 1 to 4,
wherein the feed drive unit includes an X-axis stage independently moving in the X direction and a Y-axis stage independently moving in the Y direction,
wherein the table is mounted on the X-axis stage,
wherein the machining unit is mounted on the Y-axis stage, and
wherein the correction unit corrects the tilt by integrally rotating the first machining unit and the second machining unit around an axis orthogonal to an XY plane.
